(19) Europäisches Patentamt
European Patent Office
Office européen des brevets

(11) **EP 4 589 386 A2**

(12) **EUROPEAN PATENT APPLICATION**

(43) Date of publication:
**23.07.2025 Bulletin 2025/30**

(21) Application number: **25180515.6**

(22) Date of filing: **11.05.2022**

(51) International Patent Classification (IPC):
*G03F 9/00* (2006.01)

(52) Cooperative Patent Classification (CPC):
**G03F 9/7038; G03F 9/7076; G03F 9/7088**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.11.2021 US 202163274202 P**

(62) Document number(s) of the earlier application(s) in accordance with Art. 76 EPC:
**22172781.1 / 4 174 579**

(71) Applicant: **Esko-Graphics Imaging GmbH**
**25524 Itzehoe (DE)**

(72) Inventors:
• **THOMAS, Pascal**
**22337 Hamburg (DE)**
• **WOLTERINK, Jörg**
**25524 Oelixdorf (DE)**

• **GREVE, Christian**
**25524 Itzehoe (DE)**
• **SIEVERS, Wolfgang**
**25569 Kremperheide (DE)**
• **STUBBE-THIERER, Karsten**
**12099 Berlin (DE)**

(74) Representative: **Müller-Boré & Partner**
**Patentanwälte PartG mbB**
**Friedenheimer Brücke 21**
**80639 München (DE)**

Remarks:
This application was filed on 03-06-2025 as a divisional application to the application mentioned under INID code 62.

(54) **SYSTEM AND PROCESS FOR PERSISTENT MARKING OF FLEXO PLATES WITH ISOLATED MICROSTRUCTURES AND PLATES MARKED THEREWITH**

(57) The claimed invention relates to a system for orienting a printing plate on a substrate, the system comprising a ring of LEDs visible from a front, printing surface of the printing plate disposed on the substrate, wherein the system is configured to receive a printing plate having an isolated micro alignment mark in an orientation in which the isolated micro alignment mark is characteristically illuminated by the ring of LEDs when the plate is aligned on the substrate with the isolated micro alignment mark in a desired location centered relative to the LED ring.

FIG. 1

**Description**

CROSS-REFERENCE TO RELATED APPLICATIONS

This application claims priority from U.S. Application Ser. No. 63/274,202, filed November 1, 2021, titled SYSTEMS AND PROCESSES FOR PERSISTENT MARKING OF FLEXO PLATES WITH ISOLATED MICROSTRUCTURES AND PLATES MARKED THEREWITH, which is incorporated herein by reference.

BACKGROUND OF THE INVENTION

Applicant has devised a number of systems and methods for providing persistent marking of flexo plates detailed in previously applications, including but not limited to:

- PCT Application Ser. No. PCT/EP2020/078112, filed October 7, 2020, which claims priority to U.S. Provisional Application Ser. No. 62/911,568, filed October 7, 2019, both titled "SYSTEM AND PROCESS FOR PERSISTENT MARKING OF FLEXO PLATES AND PLATES MARKED THEREWITH," which is a continuation-in-part of:

- U.S. Patent Application Ser. No. 16/559,702, titled SYSTEM AND PROCESS FOR PERSISTENT MARKING OF FLEXO PLATES AND PLATES MARKED THEREWITH, filed September 4, 2019, which is a continuation-in-part of

- U.S. Patent Application Ser. No. 16/433,873, filed June 6, 2019, which is a continuation-in-part of PCT Application Ser. No. PCT/EP19/052536, filed 1 February 2019, which claims priority to U.S. Provisional Patent Application No. 62/653,972, filed 06 April 2018, all titled "METHOD FOR PERSISTENT MARKING OF FLEXO PLATES WITH WORKFLOW INFORMATION AND PLATES MARKED THEREWITH."

The contents of all of the foregoing are incorporated herein by reference in their entirety for all purposes.

In flexographic printing, flexible photopolymer printing plates are mounted on metal cylinders that press the printing plate against a second cylinder which holds the print substrate. For today's standard multi-colour print job, printing presses have several plate cylinders for the different ink colours, which cylinders all must be aligned with respect to another, typically by mounting the plates aligned to a reference mark on the cylinder.

Most modern presses allow adjustment of the reference position of each plate cylinder to any position on the cylinder circumference. EP2397327A2 discloses non-printing registration marks applied by means of laser scribing or cutting with a knife on a cutting table into the plate floor or the plate's rear side. This is cumbersome because plates and marks had to be aligned with respect to another. Accordingly, there is a need in the art for other methods of forming alignment marks.

In particular, alignment marks have historically taken the shape of "crosshairs," which can be added to the image file. These crosshairs print in the same way as image details, but are located outside the image areas. The use of alignment marks outside of the image area consumes more plate material than is needed just for the image area, thus creating inefficiency or waste.

Furthermore, there remains a need in the art to provide better readability of a barcode, QR code or alphanumeric signs, in particular those in which the elevated level of non-printing indicia is intended to be as far as possible from the printing surface to avoid accidental printing. Such non-printing structures have only small elevation levels that may not produce a high contrast of these structures against the surrounding floor level. Indicia such as codes or alphanumeric signs on the plate floor having relatively minimal contrast are difficult to recognize and read and may benefit from special lighting conditions for proper visibility. Accordingly, there is a particular need in the art to provide improved visibility of non-printing indicia to human viewers, CCD cameras or other code readers, such as CCD scanlines or laser scanners.

SUMMARY OF THE INVENTION

One aspect of the invention relates to a process for creating a photopolymer printing plate (e.g. a flexographic printing plate, a digital printing plate, an analog printing plate, a printing sleeve, a letterpress printing plate, or a printing plate made from liquid polymer), the printing plate having a front side for receiving ink for printing on a substrate, a back side opposite the front side. The process includes the steps of providing a printing plate precursor comprising uncured photopolymer disposed between the front side and the back side, with a mask disposed on the front side, the mask having openings therein. The photopolymer is exposed to actinic radiation from the front side of the plate through the mask openings, thereby curing portions of the photopolymer sufficient to form at least a part of a floor of the printing plate precursor. Optionally, the photopolymer is also exposed to actinic radiation from the back side of the printing plate precursor. The printing plate precursor is then processed to remove non cured polymer. Embodments include creating at

least one non-printing structure having an elevation lower than an elevation of the floor and/or at least one non-printing structure having an elevation higher than an elevation of the floor. The non-printing structure may be an alignment mark for aligning the plate on a printing cylinder or for aligning the printing cylinder in a printing press.

In some embodiments, a non-printing edge is created around the at least one non-printing structure, the edge having an elevation different from the elevation of the floor and different from the elevation of the at least one non-printing structure. The mask openings may comprise a plurality of lines, such as straight lines oriented parallel to an imaging direction of the imager

Another aspect of the invention relates to a process for creating a photopolymer printing plate for use in a printing step, the photopolymer printing plate having a front side for receiving ink for printing on a substrate, and a back side opposite the front side. The process includes providing printing indicia on the printing plate, the printing indicia configured to receive and transfer ink to create a printed image in a printing step, and providing visible non-printing indicia on the printing plate configured not to receive and transfer ink in the printing step. The non-printing indicia are disposed on a floor of the plate using areas of presence and absence of polymer in the plate floor. The step of providing the visible non-printing indicia includes imaging a masking layer of a printing plate precursor and processing the printing plate precursor to produce the printing plate. The at least two types of microstructures may include a plurality of relatively smaller microstructures sized for curing polymer to a first elevation and a plurality of relatively larger microstructures sized for curing polymer to a second elevation, such as wherein the first elevation defines the plate floor and the second elevation is defined above the plate floor, or vice versa. At least one of the two types of microstructures may comprise microdots and/or at least one of the two types of microstructures may comprise microlines. The process may include forming a non-printing edge around the non-printing indicia, the edge having an elevation different from an elevation of the floor and different from an elevation of the at least one non-printing indicia. The non-printing indicia may comprise an alignment mark for aligning the plate on a printing cylinder or for aligning the printing cylinder in a printing press. In embodiments, the floor of the plate may be made without exposing the printing plate to actinic radiation from the back side of the plate.

The alignment mark may comprise an isolated micro alignment mark, such as an isolated micro alignment mark formed by superimposing a repeating pattern of microstructures over a solid dot shape.

Other aspects of the invention relate to products of the any one of the processes described above.

Yet another aspect of the invention relates to a system for orienting a printing plate on a substrate. The system comprises a ring of LEDs visible from a front, printing surface of the printing plate disposed on the substrate, wherein the system is configured to receive a printing plate having an isolated micro alignment mark as described herein, in an orientation in which the isolated micro alignment mark is characteristically illuminated by the ring of LEDs when the plate is aligned on the substrate with the isolated micro alignment mark in a desired location centered relative to the LED ring. The system may further include a camera oriented to capture an image of the isolated micro alignment mark in the desired location and a display for displaying the captured image.

A related method for orienting a printing plate includes providing a ring of LEDs disposed to illuminate a surface of the plate, illuminating the ring of LEDs, providing an isolated micro alignment mark as described herein in an illumination field of the ring of LEDs while observing light reflected by the plate, and adjusting a location of the plate until a characteristic illumination pattern of the isolated micro alignment mark by the ring of illuminated LEDs is observed, signifying that the isolated micro alignment mark is centered relative to the LED ring.

Still another aspect of the invention includes a system for making a photopolymer printing plate, the system comprising means for providing non-printing indicia on the photopolymer printing plate, the non-printing indicia disposed on a floor of the plate using at least two types of microstructures, including a first plurality of microstructures sized for curing polymer to a first elevation and a second plurality of microstructures sized for curing polymer to a second elevation.

Yet another aspect of the invention includes a non-transitory computer readable storage medium having data stored therein representing instructions for imaging a first plurality of printing mask openings defining a screened image for resolving to printing structures on a flexographic printing plate and a second plurality of non-printing mask openings defining non-printing indicia comprising at least two different types of microstructures. The storage medium may further include instructions for imaging mask openings that resolve to at least a portion of a floor of the printing plate, wherein one of the at least two different types of microstructures is configured to resolve to the floor of the plate and another of the at least two different types of microstructures is configured to resolve to an elevation above or below the floor of the plate. The storage medium may further include instructions for imaging mask openings that resolve to a non-printing edge of the at least one non-printing indicia, the edge having an elevation different from the elevation of the floor and the elevation of the at least one non-printing indicia. At least one of the at least two different types of microstructures may comprise a linear microstructure.

Still another aspect of the invention includes a process for making a printing plate, such as a flexographic printing plate, the process comprising providing non-printing indicia disposed on a floor of the printing plate using areas of presence and absence of polymer in the printing plate floor, wherein the non-printing indicia is disposed on a floor of the printing plate in form of structures derived from imaging microdots, wherein the non-printing indicia comprises human-readable text oriented for reading from a back side of the plate. The method may include viewing the non-printing indicia directly from the back side of the plate while illuminating the back side of the plate, and/or viewing a projection of an image of the indicia on a surface disposed a distance from a back of the plate formed by directing illumination from the front side of the plate through the plate and onto the surface.

Yet another aspect of the invention relates to a system for orienting a printing plate relative to a workstation. The system includes a ring of LEDs disposed to illuminate a surface of the printing plate, a positioner for positioning the ring of LEDs in a predetermined alignment position, means for adjusting a location of the plate relative to an illumination field of the ring of LEDs, and means for detecting a characteristic illumination pattern of an isolated micro alignment mark disposed on a surface of the printing plate, signifying that the isolated micro alignment mark is centered relative to the LED ring. An image capture device may be disposed to capture light from the ring of LEDs as reflected by the printing plate. The means for detecting the characteristic illumination pattern may comprise a machine vision system.

Another aspect of the invention relates to a process for making a printing plate, including providing non-printing indicia disposed on a floor of the plate using areas of presence and absence of polymer in the plate floor. The non-printing indicia is disposed on a floor of the plate in form of structures derived from imaging a plurality of supercells defined by a plurality of exposed pixels and unexposed pixels disposed within a supercell boundary. Each supercell has a first number of exposed pixel clusters, each exposed pixel cluster comprising a second number of exposed pixels, the exposed pixel clusters spaced apart from one another by a third number of unexposed pixels, and padding between the boundary and a closest exposed pixel cluster is defined by a fourth number of unexposed pixels. In embodiments, each supercell includes five exposed pixel clusters including a central pixel cluster, and four outer pixel clusters, wherein each outer pixel cluster has an innermost corner spaced diagonally from a corner of the central pixel cluster by the third number of unexposed pixels, and the fourth number of pixels defines a diagonal arrangement of pixels from an outermost corner of each outer pixel cluster to a corner of the supercell boundary. The non-printing indicia may include one or more crossing regions where a first character portion crosses a second character portion, wherein an elevation of the crossing region of the non-printing indicia is the same as an elevation of a non-crossing region of the non-printing indicia.

Aspects of a related invention relate to non-transitory computer readable storage medium having data stored therein representing instructions for imaging a first plurality of printing mask openings defining a screened image for resolving to printing structures on a printing plate and a second plurality of non-printing mask openings defining non-printing indicia having the foregoing characteristics.

Another aspect of the invention relates to a process for placing non-printing image information on a floor of a flexographic photopolymer printing plate. The method includes forming a series of isolated non-printing dots corresponding to the non-printing image information, each dot in the series of isolated dots having a non-printing elevation above or below the plate floor. The series of isolated dots forms one or more patterns that represent one or more alphanumeric signs, digital codes, or alignment marks. The process may include disposing a mask on top of the photopolymer plate in an uncured state, imaging the mask to form an imaged mask in accordance with an image file comprising machine readable instructions that are based at least in part upon the non-printing image information, curing the photopolymer with actinic radiation through the mask, and removing uncured polymer, wherein each isolated non-printing dot on the plate corresponds to a presence of a supercell comprising a pixel cluster of openings in the mask. Characteristics for the supercell may be based upon plate type, plate thickness, curing parameters of the actinic radiation, and resolution of image file. A plurality of optimal supercell characteristics as a set of machine readable instructions may be stored in a computer memory library, and the selecting step may include selecting the characteristics for the supercell from the computer memory library with a computer, and forming the machine readable instructions in the image file corresponding to the non-printing image information based upon the selected characteristics. The mask may be a laser ablateable mask, a photosensitive film, or a thermosensitive film.

Positioning the isolated non-printing dots on the plate floor may be calculated by segmenting a non-printing image file containing non-printing image information into individual sections that correspond to the size of the supercell and combining each section of the non-printing image file information with a supercell by conjunction. The supercell may be combined with the non-printing image information by conjunction and the resulting combined non-printing image information may be combined with printing image information by disjunction, such as an OR operation or a NAND operation.

Another aspect of the invention relates to a printing plate that is a product of any of the processes discussed herein.

Still another aspect of the invention includes a printing plate may include non-printing elevations on a floor of the plate floor comprising a plurality of isolated microdots arranged in a pattern corresponding to one or more alphanumeric signs or codes. The alphanumeric signs or codes may correspond to information about the plate, processing parameters for the plate, or use of the plate, or to a link to a data file stored in computer memory containing machine readable instructions corresponding to the information about the plate, the processing parameters for the plate, or the use of the plate.

Yet another aspect of the invention relates to process for communicating information on an article, which may include but is not limited to a printing plate. The process includes forming on a surface of the article a series of isolated optical-property-altering dots corresponding to the information, each dot in the series of isolated dots having an elevation above or below a surrounding surface of the article, the series of isolated dots forming one or more patterns that represent one or more alphanumeric signs, digital codes, or processing marks, and reading the one or more patterns based upon distinguishable optical properties between light applied to the series of isolated dots relative to light applied to the surrounding surface of the article. The isolated dots may be formed with a transparent or translucent coating. A protective layer may be laminated over the dots formed by the coating. In embodiments, the surrounding surface of the article may be opaque.

In embodiments in which the article includes a photopolymer printing plate, each isolated dot is a non-printing dot that has an elevation above or below a floor of the plate. The process of forming the isolated dots includes disposing a mask on top of the photopolymer plate in an uncured state, imaging the mask to form an imaged mask in accordance with an image file comprising machine readable instructions that are based at least in part upon the non-printing image information, curing the photopolymer with actinic radiation through the mask, and removing uncured polymer. Each dot corresponds to a presence of a supercell comprising a pixel cluster of openings in the mask, and may be elevated relative to the plate floor, the process may include forming a matrix of supercells that define a raised area, wherein selected absences of supercells define sunken structures relative to the raised area that form the one or more patterns. Any of the one or more patterns described herein may comprise a digital 2-dimensional code, and the reading may be performed by a camera connected to one or more processors. The one or more processors may translate the information embodied by the isolated dots and read by the mobile device into an instruction readable by a machine or into alphanumeric information readable by a human.

BRIEF DESCRIPTION OF THE DRAWINGS

FIG. 1 is a cross-sectional schematic view of a portion of an exemplary printing plate, showing the LAMS layer and mask openings therein for creating printing and non-printing information, wherein the non-printing information is embodied in structures above the plate floor but below a printing elevation.

FIG. 2 is a cross-sectional schematic view of a portion of an exemplary printing plate, showing the LAMS layer and mask openings therein for creating printing and non-printing information, wherein the non-printing information is embodied in depressions below the plate floor.

FIG. 3 is a plan view of a LAMS layer of an exemplary plate showing open areas in white, non-open areas in black, and areas comprising a plurality of microstructures in gray.

FIG. 4 is a plan view of a LAMS layer of another exemplary plate showing open areas in white, non-open areas in black, and areas comprising a plurality of microstructures in gray.

FIG. 5 is a plan view of a LAMS layer of yet another exemplary plate showing open areas in white, non-open areas in black, and areas comprising a plurality of microstructures in gray.

FIGS. 6A-6F each depict exemplary alignment marks.

FIG. 7A illustrates an exemplary alignment mark defined with microdots.

FIG. 7B illustrates an exemplary alignment mark defined with linear microstructures.

FIG. 8A illustrates an exemplary illustrative grid of cells, each corresponding to a pixel in an image file used for forming a mask, in which information corresponding to microdot structures is defined.

FIG. 8B illustrates an exemplary illustrative grid of cells, each corresponding to a pixel in an image file used for forming a mask, in which information corresponding to linear microstructures having a first width is defined.

FIG. 8C illustrates an exemplary illustrative grid of cells, each corresponding to a pixel in an image file used for forming a mask, in which information corresponding to staggered linear segment microstructures is defined.

FIG. 8D illustrates an exemplary illustrative grid of cells, each corresponding to a pixel in an image file used for forming a mask, in which information corresponding to linear microstructures having a second width is defined.

FIGS. 9A-9C illustrate exemplary grids of cells showing exemplary spacing between microdots relevant to exemplary commercial applications.

FIGS. 10A-10D are exemplary illustrative stacks of a plan view illustration of a portion of a LAMs layer, a graph of a relative amount of light intensity transmitted through the corresponding portion of the LAMS layer, and a cross-sectional view of the corresponding plate structure created on the plate by the transmitted light.

FIG. 11A depicts exemplary written indicia for incorporating into a plate.

FIG. 11B depicts a plate with the exemplary indicia of FIG. 11A incorporated therein, viewed from a back of the plate with back side illumination.

FIG. 11C depicts a plate with the exemplary indicia of FIG. 11A incorporated therein, viewed from a back of the plate with no back side illumination.

FIG. 11D depicts a plate with the exemplary indicia of FIG. 11A incorporated therein, viewed from a back of the plate with back side illumination.

FIG. 12A depicts a 31x31 pixel solid dot.

FIG. 12B depicts a pattern of microstructure forming dots.

FIG. 12C depicts a resulting micro alignment mark formed by combining the dot of Fig. 12A with the microstructure pattern of 12B.

FIG. 13A depicts an exemplary micro alignment mark centered relative to a ring of LEDs.

FIG. 13B depicts the exemplary micro alignment mark in an uncentered location relative to the ring of LEDs.

Fig. 13C depicts the exemplary micro alignment mark of FIG. 13A in another uncentered location relative to the ring of LEDs.

FIG. 14 depicts a table of exemplary images of exemplary different micro alignment marks illuminated by a ring of LEDs, and corresponding microstructure pattern information, height above the plate floor, and an indication of whether the micro alignment marks printed.

FIG. 15A depicts a plan view of an exemplary ring of LEDs and related optics aligned therewith.

FIG. 15B depicts a side view of the exemplary ring of LEDs and related optics positioned relative to a micro alignment mark on a plate aligned therewith.

FIG. 16 depicts an exemplary supercell comprised of microclusters for forming indicia on a plate as described herein.

FIG. 17 depicts a plurality of supercells of varying dimensions with reference to corresponding nomenclature

FIG. 18A depicts an alphanumeric character with an intersection point.

FIG. 18B depicts the alphanumeric character in a digital arrangement of 1s and 0s.

FIG. 18C depicts the alphanumeric character of FIG. 18A in an arrangement of microclusters.

FIG. 19 depicts an exemplary arrangement for reading indicia formed on a plate.

FIG. 20 is a photograph of exemplary non-printing indicia on a printing plate that define solid interrelated structures.

FIG. 21 schematically depicts exemplary differences between light applied to non-printing microdots as compared to surrounding surface areas.

FIG. 22A schematically depicts an exemplary 21 x 21 matrix QR-code made from interrelated structures.

FIG. 22B schematically depicts the QR-code of FIG. 22A with a visible grid.

FIG. 22C schematically depicts the same code and grid of FIG. 22B with the resolution of the grid doubled.

FIG. 22D depicts the same QR code of FIGS. 22A-C with elevated details deleted in every other row and column

FIG. 23 depicts the exemplary code of FIG. 22D in which each individual dot of the code pattern is replaced by a matrix of image file pixel clusters.

FIG. 24 depicts a photograph of the resulting, non-printing QR code pattern of FIG. 23 as formed on the floor of a plate.

Fig. 25 shows the mask opening pixels of a supercell with respect to their position on the image file grid.

FIG. 26 is a photograph depicting an exemplary plurality of microdots as described herein.

FIG. 27 is a graph depicting the results of a depth analysis using a confocal microscope of the microdots depicted in FIG. 26.

FIG. 28 is flowchart depicting the steps of an exemplary process in accordance with one embodiment of the invention.

FIG. 29 schematically depicts an exemplary system for reading an exemplary pattern of isolated dots as described herein.

FIGS. 30A-30D schematically depict an AND conjunction operation performed using two sets of image information.

FIGS. 31A-31D schematically depict an OR disjunction operation performed using two sets of image information.

FIGS. 32A-32D schematically depicts a NAND disjunction operation performed using two sets of image information for turning off selected supercells to form sunken structures relative to a raised area.

DETAILED DESCRIPTION OF THE INVENTION

The term "indicia" as used herein is intended to have its broadest meaning of "an indication" or "distinguishing mark," without limitation to how that indication or mark is capable of being read, and thus the "equivalents" of the indicia as expressly described are intended to be broadly construed. While certain machine-readable indicia or codes may take advantage of formats that are exclusively machine readable to permit a large volume of information to be stored in a small amount of space, it should be understood that the term "machine readable," as used herein to refer to indicia and codes, is not limited to indicia having a format that is exclusively machine-readable. Those of skill in the art will appreciate that human readable alphanumeric information is also machine readable by a reader equipped with suitable optical character recognition (OCR) functionality, and that the hardware and software for providing such functionality is well known in the art and becoming more ubiquitous. The terms "indicia" and "machine readable" are intended to be broadly interpreted to include, without limitation, in addition to the other types of indicia discussed in detail herein, printed or otherwise visible alphanumeric or graphical information configured to be read and comprehended by human operators as well as machines, as well as combinations of indicia that are exclusively machine readable with indicia that is both human and machine readable. One advantage of using machine-readable indicia that is also at least partially human readable, is that an experienced human operator may be able to process and act upon at least some codes faster than it would take that same operator to enlist the assistance of a machine.

In some embodiments, the code for a printed code, such as a bar code or a QR code or printed indicia comprising text and/or graphics readable by a human or machine, may be added during ripping the image file and is thus included in the content of the image information, such as in the .LEN file or encrypted LENx file associated with an Esko PlatePrep workflow. Adding a code to an image file may be accomplished using, for example, Esko DeskPack™ barX software, which software comprises machine-readable instructions embodied in storage media, such as a hard drive, a flash drive, or any type of media, as is well known in the art.

As described herein, the imaged information may be provided in the form of non-printing structures on the plate floor formed using microdots, including in the form of a non-printing watermark derived from the use of non-printing microdots in a printing portion of the plate. Such structures formed from microdots may be created on a flexo plate using an Esko® XPS exposure system.

The term "microdots" as used herein primarily refers to small mask openings in the LAMs layer of a flexo plate, wherein each opening is not wide enough to grow a printable screen dot in isolation (under normal power), but clusters of them (or single pixels with sufficient boost) are operable to raise the plate floor level. The term microdot may also refer to any dot used in any imaging step by any process capable of creating a non-printing dot structure on a plate, including but not limited to direct curing processes and non-LAMS mask-based processes. As used herein, the term "microdot" may be used to refer to a feature in the image information used by the imager for creating the plate or mask structure, as well as the plate structures formed thereby. In some embodiments, a cluster of microdots may be used to form sections of elevated floor relative to other sections of the floor that remain non-elevated and arranged in a formation resembling the dark and light sections in a QR-code or a barcode. In general, the arrangement of microdots is object-based, meaning the amount, distance and pixel cluster size of the microdots varies with size and shape of an alphanumeric sign or code object such as a barcode or a crosshair. In other embodiments, described in more detail below, microdots may be used to form the floor and an absence of such microdots may be used to provide depressions in the floor. In still other embodiments, microdots may also be used to create a combination of elevated and depressed structures relative to a predetermined floor level. The microdots in the mask result in microstructures (elevations or depressions) in the exposed plate.

The term "watermark" is used herein as an analog to the original definition of the term for the identifying images or patterns on paper that appear as various shades of lightness/darkness when viewed by transmitted or reflected light (at certain angles or atop a dark background), caused by thickness or density variations in the paper. Such watermarks are often visible in the paper constituting an original document, but not in reproductions (e.g. photocopies) made from that paper. By analogy, the non-printing watermark formed in accordance with embodiments of the invention may be more visible under certain conditions (e.g. reflected light at a certain angle) and comprise a variation in thickness of the plate, with the markings not reproduced in printed matter made by the subject plate.

As understood to those of skill in the art, microdots are clusters of tiny mask openings in the LAMs layer of the photopolymer plate, the amount of UV light (or other actinic radiation) is not great enough for curing structures on the plate floor that reach the top of the plate, but it is sufficient to create structures on the plate floor that are typically visible.

Several parameters have influence on the growth of non-printing structures on the plate floor. For example, a microdot mask opening has a diameter that is small enough not to grow printing dots that reach the plate's printing surface, but is still wide enough to allow a sufficient amount of energy to enter the polymer to cause polymer chain growth. The mask opening may be modified by the number of pixels in the image that build each microdot mask opening or by the laser power for individual pixels used in imaging the mask, such as using ESKO pixel boost technology. The distance from one opening to another affects the amount of energy per surface unit that can enter the plate. The curing radiation (e.g. UV light) intensity and exposure time, and number of repeating exposure steps also affect the structure growth for a given mask opening size. The sensitivity of the photopolymer also has an influence on structure formation, and the washing parameters have an effect on the structures that remain on the plate, particularly for microdot structures not polymerized to the plate printing surface.

One application for non-printing structures on the floor may be for checking the alignment of a plate on the printing cylinder. For this purpose, a line may be formed on the floor in an orientation parallel to the circumference of the printing cylinder. During mounting the plate, or later in the press, this line can be used to check the correct parallel alignment of the plate with respect to the printing cylinder or sleeve.

Thus, as described herein, microdots are created by openings in the mask by ablating clusters of pixels in regular distance in the LAMs layer, or by ablating only single pixels in the LAMs and boosting the laser power for ablation such that the total width of the mask opening is adjusted to the desired value, such as for example, by using a Gaussian Beam profile for the ablation.

Various method may be used for providing the image information for the non-printing structures in the image file used for controlling ablation of the mask.

In one embodiment, a 1-bit image file (e.g. a LEN-file of the non-printing image) may be combined additively with another 1-bit image file that contains screen information for suitable microdots. The combination of non-printing image and screen is conjunctive in that only overlapping pixels of non-printing image and screen produce a pixel in the resulting file. The screen may comprise conventional screen dots built from clusters of pixels or single pixels later boosted during imaging of the LAMs. The combined non-printing image / screen file is then combined with the 1-bit image file that contains the image information for the printing structures (which itself may comprise a combination of an image file and a screen). The combination of non-printing and printing 1-bit image files is disjunctive, in that pixels from both files are included in the resulting combination file, regardless of overlap. This process may be performed on the fly during the imaging process.

To avoid undesired changes in the highlights of the image, however, it may be desirable to block non-printing dots from overlapping with certain details of the printing files. An exemplary method for combining files may start with the original 1-bit printing file and original 1-bit non-printing file, with an adjusted 1-bit printing file created by placing vignettes around the image information in the original 1-bit printing file. Then, the vignetted 1-bit printing file is combined with the original 1-bit non-printing file with a function that dictates that if a bit is "ON" in the vignetted printing file, it will be turned OFF in the non-printing file, thereby creating a corrected 1-bit non-printing file. The corrected 1-bit non-printing file is then combined with the original 1-bit printing file to create the finalized file for RIPping.

Another method of creating such vignettes in a vector-based image file is to increase the thickness / diameter of the pen used to draw the printed objects substantially enough to create objects that build vignettes around the original objects in the file.

The vignettes may be created during ripping the image files or later in a merger application (e.g. the ESKO Merger) before a job is sent to the exposer of the imager (e.g. a CDI Imager).

Image information is often provided by PDF files. PDF files often contain different layers (e.g. for different ink colors). Accordingly, the non-printing image may be contained in a dedicated layer of the PDF file. This image is then ripped by the RIP with the screen of microdots.

As it is advantageous to create different microdot structures in the mask, the PDF layer for non-printing images may contain gray level information. Different gray levels may be assigned to different microdot sizes or different numbers of microdots per surface unit by using a raster pyramid tile.

Indicia may be created in the plate floor as an inverse structure, in form of a depression at a predetermined height below the floor, rather than a predetermined elevation above the floor. One exposure process for making such depressions is to create a first subfloor at a relatively lower height than the desired final floor by using less exposure energy than is required to create the height of the desired final floor. In a second step, areas of the desired final floor are formed via an exposure step using microdot openings in the mask. In locations in which the desired inverse indicia is located, no mask openings (microdot or printing) are formed in the corresponding portions of the mask.

The advantage of using depressions rather than elevations is that it avoids any accidental printing of elevated structures on the floor in locations in which those elevations may interfere with desired highlights in the printing area. In one embodiment, a constant screen of microdots is combined disjunctively with the printing image information to create the normal floor (e.g., pixels already turned "on" based upon image information remain "on," and pixels corresponding to microdots are turned "on" only in locations previously "off"). At places where non-printing indicia in the form of depressions are located, the microdot screen is omitted (and the corresponding pixels remain "off"). In a more elaborated embodiment, microdots may additionally be arranged in concentric circles around certain printing screen dots (e.g. to form non-printing support dots in highlight areas, based on image information), as suggested in EP 1 557 279 B1. For complete highlight regions in the image file, the micro screen for creating the floor may be adjusted according to the halftone screening percentage instead of calculating microdots for every single printing highlight dot.

Although described above with respect to an exemplary process of creating plate structures arising from microdots in a LAMS layer, it should be understood that the invention is not limited to use in LAMS-based processes. Any process known in the art for creating a printing plate may be used for creating non-printing indicia as described herein, including but not limited to exposure of photopolymer plates by actinic radiation in any range of wavelengths, including plates created by direct imaging or using masks imaged by any process known in the art.

In embodiments in which the non-printing image information is imposed using a masking component, the masking component may be a film or LCD matrix having transparent and non-transparent areas. The masking component may be the same size (e.g. width and length) as the polymer plate (or the combination of source, masking component, and optics (optional) may project an image that is the same size as the polymer plate, or any desired size). In other configurations, the masking component may only cover (or only create a projection that covers) less than the full area of the plate, and the overall system may be positionable to create non-printing indicia in specific desired locations, which locations may be coordinated, such as via a controller which may have information about printing and non-printing information, to correspond to locations on the plate lacking printing features. The masking component may have a multitude of markings (e.g. brand logos), such that the markings may be distributed throughout the polymer plate floor like a watermark. The method may be implemented in a single exposure step without a need to move the plate relative to the UV source and/or masking component. The source emits radiation that passes through transparent (or relatively more translucent) areas or holes in the masking component and is blocked by opaque, non-transparent (or relatively less translucent) areas, and is optionally focused by optics (in some embodiments), such that the radiation forms non-printing features in the photopolymer above the floor of plate. The plate may have a backing layer, as is known in the art. Printing features may be formed by any method known in the art, typically by exposure to actinic radiation through holes in the mask. In embodiment in which the masking element has relatively less translucent and relatively more translucent areas, the relatively less translucent areas may be used for forming the floor, whereas the relatively more translucent areas may be used for forming the non-printing indicia in a single step, or a series of steps, in which the full or partial primary exposure for forming the floor and full or partial additional exposure for forming the non-printing indicia are performed simultaneously.

For printing plates having front-side images comprising a significant amount of screened artwork, the non-printing image information may be advantageously imposed only at locations on the plate where no printing details are present, to avoid changes in size of highlight screen printing dots.

Any of the exposure configurations disclosed in U.S. Published Patent Application US20180210345A1 may be used for forming both printing and non-printing structures. The source may comprise an LED matrix of individual LEDs in an array that covers the full width and length dimensions of the plate. Thus, relative motion between the plate and the back side source may not be required for exposure of the back surface of the plate. Likewise, systems in which the front source also comprising an LED matrix of individual LEDs in an array that covers the full width and length dimensions of the plate may be provided, in which case relative motion is not required for either front side or back side exposure.

Individual LEDs in any of the LED arrays or matrices as described herein may include multiple species of LEDs, each species having a different center wavelengths, and may be spaced in any pattern desired, such as is described in U.S. Provisional Application No. 62/839,171, titled APPARATUS AND METHOD FOR EXPOSING PRINTING PLATES USING LIGHT EMITTING DIODES, filed April 26, 2019, and incorporated herein by reference.

While referred to primarily herein in connection with UV radiation, any radiation source capable of emitting actinic radiation operable to cure a corresponding photopolymer may be used. The invention is not limited to any particular methods for providing radiation. Other methods and systems for projecting the radiation into the polymer that builds structures on the plate floor using diverging light cones that enter the plate from different points of the plate surface and combine in higher photon concentrations on the plate floor are favored. The source may take the form of a point source, planar source, linear source, compound source, or any type of radiation source known in the art, having any dimension, without limitation.

Non-printing features may be raised above the floor a lesser amount than the printing features, or in the form of depressions relative to the floor. In such configurations, the apparatus and methods as described above may be implemented to create a first, subfloor level using the primary exposure, and then using the additional radiation to create the floor at a level above the subfloor. Thus, the non-printing features will remain at the height of the subfloor at a desired distance below the floor.

Controllers for equipment performing any of the method steps as described herein may be programmed with machine-readable instructions, which instructions may reside on any non-transitory computer readable storage medium, including but not limited to a hard disk, a flash drive, a server in the cloud, or distributed among multiple locations "on the cloud" and on a local network. The instructions may include a first set of instructions for imaging a first plurality of printing dots defining a screened image and a second set of instructions for imaging non-printing indicia. The non-printing indicia may define features selected from the group consisting of: alphanumeric characters, non-text graphics, a machine readable code, a line, and combinations or repeating patterns of any of the foregoing.

The process for making a flexo plate may have a plurality of process steps, such as at least an imaging step, a curing step, a washing step, a cutting step, a printing step, and a storage step, each step performed by a processing machine having at least one variable operating parameter. It should be understood that some processes do not require a cutting step. In some processes, plates are discarded after the printing step and are not stored. Thus, cutting and storage steps are optional, depending upon the process.

Although the invention is not limited to any particular information or instructions embodied in the machine-readable indicia, each process step may have certain parameters that are particularly well suited for expressing in on-plate, non-printing indicia. For example, in a mounting step, the indicia may contain information indicative of the physical position of the plate/slug/patch on a substrate or printing sleeve (e.g., flexo plate left printing lane / middle printing lane / Right printing lane). The indicia may also contain information indicative of the physical coordinates for the mounting cameras of the mounting device. Similarly, in a curing step, such as a UV curing step, the instruction may provide UV exposure parameters, such as exposure time, intensity, and the like. In a "washing" or other non-cured-polymer-removal step, the instructions may comprise processing parameters such as temperature, time, and type (water, solvent, thermal). In a plate-cutting step, the instructions may include the corresponding cut file and cutting parameters, such as type of cutting blade, thickness and type of the substrate to be cut, and the like. In a quality control step, the instructions may include instructions for loading a specific portion of the plate under process to a device for conducting a quality control (QC) evaluation, along with information for verification relative to information detectable using the device. For example, the evaluation device may be a monitor in which the loaded information is an image of the portion of the plate that can be viewed by the human operator, or the device may be a sensor for measuring plate height or dot shape or size, and the measured value may be automatically compared against a stored value. QC steps may be performed at any point in the workflow. In the printing step, the parameters may include any specialized inks to use, color curves to apply, as well as instructions regarding what location of the printed result should be the subject of a QC evaluations using the onboard machine vision system, such as systems made by AVT, a subsidiary of Danaher Corporation.

Any number of other process parameters may be included instead or in addition, and the invention is not limited to any particular process parameters for any particular process step, nor does each indicia necessary contain information corresponding to each process step. It should be noted that although discussed herein in the context of a single indicia, the amount of data to be stored may exceed what is practical to embed in a single instance of certain types of indicia. Accordingly, multiple indicia may be used.

FRONT SIDE EXPOSURE TECHNIQUES

Forming information on the plate floor directly by the same mask that also forms the printing elements on the polymer printing plate may have certain advantages. With respect to the formation of indicia in the nature of alignment marks, such techniques automatically provide an exact alignment between the image to be printed and the alignment marks. Alignment marks include registration marks used for aligning a plate on a cylinder, alignment marks for aligning a cylinder on a press, and any other type of mark used for physically aligning elements in a printing and/or cutting workflow using indicia on the plate.

Alignment marks and other three-dimensional structures may be formed in the plate floor using mask openings and UV exposure from the plate's front-side through these mask openings. In particular, alignment marks may be created via UV exposure from the front side by through mask openings in form of a high frequency screen imaged together with printing image information during the process of laser ablation of the mask on top of a digital polymer printing plate. An analogous method may also be applied with, e.g. non-digital (analog), plates that use a separate film to form printing and non-printing structures on the polymer plate.

As alignment marks are at identical locations of the plate for all plates of one print job, placing them using front exposure through the same mask that is used for imaging printed content allows for alignment of all plate cylinders directly in the press. While creating printable reference marks using front side exposure is known, and certain methods of creating non-printable references marks is described in US9375916B2, assigned to the Applicant for the present invention, described herein are alignment marks having different features and advantages than those previously described in the art.

Different combinations of elevated and non-elevated structures on the plate floor may be utilized for creating alignment marks to align plates in printing presses or on cutting tables. Certain combinations of floor level and elevated non-printing structures help to improve the visibility of marks and plate ID information.

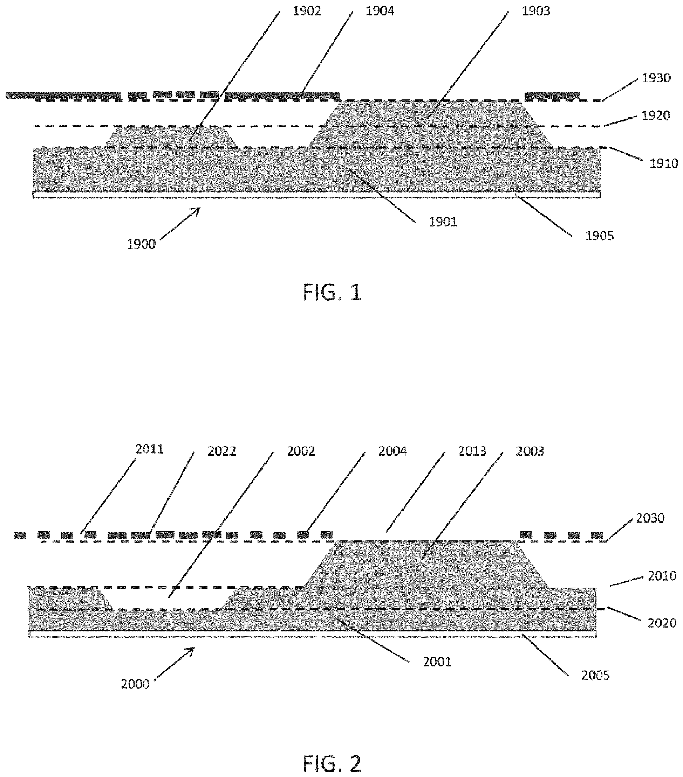

Exemplary non-printing structures of this nature are depicted in Fig.1, which shows a cross section of a photopolymer plate 1900 comprising the plate floor 1901, which holds elevated non-printing structures 1902 and printing structures 1903. On top of printing surface is the Laser Ablateable Mask (LAMs) 1904 and on the opposite side of the polymer a substrate 1905 or foil of (e.g. polyester, such as polyethylene terephthalate (PET)) provides dimensional stability of the plate. Three different elevation levels are shown in FIG. 1: floor level 1910, non-printing level 1920, and print surface level 1930.

The non-printing structures can also be applied as sunken structures, as depicted in FIG. 2. Here, the non-printing structures do not extend above the floor level, which has the advantage that the risk of accidental printing is minimized. The floor 2001 is created partially or completely through mask openings 2011 in the LAMs layer 2004. In contrast to Fig.1, the elevation 2020 of non-printing structures 2002 stays is defined below the floor level. This level 2020 is either determined by back side exposure and a non-perforated LAMs above or by front exposure through mask openings 2022, which are smaller than mask openings 2011. Printing structures 2003 at printing level 2030 are defined by one or more openings 2013 that are larger than openings 2011 or 2022. Openings may include, but are not limited to, openings that conform to a base pattern, such as is described in U.S. Published Patent Application No. 20190315141A1, incorporated herein by reference.

This method for creating alignment marks in flexographic printing plates may be used for packaging printing as well as for flexographic printing plates used for corrugated printing. The same principle can also be applied to photopolymer letterpress plates e.g. used for label printing. Furthermore, it can be applied to sleeves and plates made from liquid photopolymer.

The high frequency mask openings as described herein may also be used solely to create the floor, advantageously eliminating a need for back exposure and a back exposure "teach-in" for plates from different batches. As is known in the art, back exposure through a plate's rear side often requires a "teach-in" (re-checking rear exposure parameters) each time a new batch of plates is used, because UV transmissivity of the rear substrate may vary from one plate batch to another. By contrast, the polymer and the LAMs layer have more stable properties that do not significantly vary from one batch to another. Thus, exposing the floor through the front side with constant parameters is more predictable than methods that use back exposure, as using all front exposure eliminates the need for checking the floor curing parameters when a new batch of plates starts.

In addition to making back-exposure process steps obsolete, this process may also lead to faster main UV exposure when combined (or not) with a back-exposure, because often back exposure from the plate rear side slows down the overall process time for the UV exposure process.

For historical reasons most photopolymer printing plates have an UV blocker in the PE-sheet 1905, 2005 on the back side. Photopolymer plates were initially designed for bank exposure. Most polymers are so sensitive that back exposure without any UV blocker in the PE sheet takes only 2 or 3 seconds, making it difficult to control the floor thickness precisely. For example, use of an UV-blocker in the PE sheet that reduces the irradiance to 10 % of the incoming light, extends the resulting back-exposure time from the former 2-3 seconds to 20 or 30 seconds, which is easier to control.

Modern exposure devices comprising UV LEDs have a lower total available UV Power for back exposure over time compared to a bank exposure device, but the energy can be controlled more precisely. In UV LED systems, the UV blocker in the PE back sheet has become a disadvantage that slows down the overall process. Therefore, exposing and creating the floor through the front side using non-printing structures, where no UV blocker is present, can speed up the overall UV curing cycle and may also eliminate the need for a rear side exposure head.

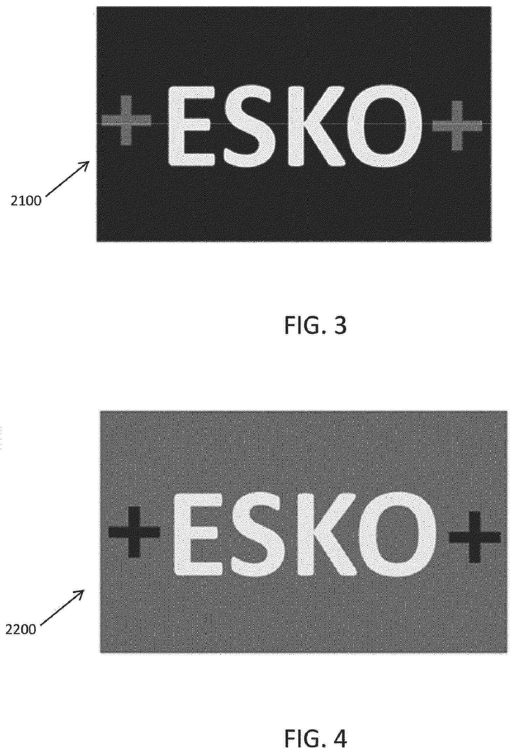

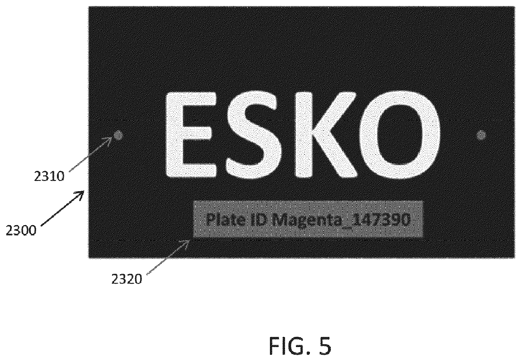

FIGS. 3 to 5 show different application examples of non-printing alignment marks. The figures show respective plan views of a plate 2100, 2200, 2300 after imaging, before processing. Black areas represent the unablated LAMs disposed on top of the photopolymer, which after exposure and further processing, resolves to portions of the printing plate at the floor level. White areas represent areas with the LAMs ablated with printing structure sized openings, which resolve to structures of cured polymer at the printing surface of the plate. Gray areas represent areas of the LAMs perforated by many small mask openings, which resolve to cured polymer at a height below the printing surface but above the floor level surface defined by the black areas. A like process can also be implemented on a photopolymer plate or to liquid photopolymer by using a film placed on top of the plate instead of a LAMs layer. Plates 2100 and 2200 illustrate exemplary plates suitable for use in a corrugated application, and plate 2300 illustrates an exemplary plate suitable for use in a flexible packaging application. Plate 2300 includes not only alignment marks 2310, but also non-printing identification indicia 2320.

The method as described above is not limited to creating alignment marks, but can also be used to create other non-printing structures, such as but not limited to, user-specific information like barcodes, logos, letters or identification numbers, and the like.

Various parameters have an effect on the visibility and size of the non-printing objects on the plate floor, including but not limited to: plate thickness, plate (polymer) type, targeted relief thickness (the distance between plate floor level 1900 and printing surface level 1930), size of the mask opening (number of connected pixels that build one common area of mask opening), distance between the mask openings, UV exposure parameters (UV irradiance, UV energy/cm$^2$ angular Light distribution), and processing parameters (type of processor, type of solvent, condition of brushes, temperature, speed)

One challenge when creating non-printing objects from high line count halftone screens in the LAMs is the limitation of the smallest size of a non-printing object due to the number of available halftone dots for the desired elevation level. The mask openings for creating the object comprise basically a certain number of pixels which all together determine the size of the mask opening area for the non-printing object. These pixel clusters must not exceed a maximum number of pixels for a given combination of plate parameters (e.g. listed above), otherwise they will create an object that extends to the print surface level. For the same reason the pixel clusters must keep a certain distance from one another, otherwise they support each other in a way that most of them likewise extend to the print surface level. This circumstance creates a certain grid that determines the smallest detail of a non-printing object on the plate floor that still can be created by the pixel cluster.

In general, it is easier to create non-printing structures in printing plates for flexible packaging because these plates are thinner and the distance between mask 1904 on the printing surface level 1930 and the floor level 1910 is smaller than for some other types of printing plates. While plates for flexible packaging (commonly referred to as "flexo plates") typically range in thickness between 0.76 and 1.7 mm (0.03 - 0.067 "), plates for corrugated printing (printing on corrugated cardboard) typically range between 2.54 and 7.11 mm (0.10 - 2.8"). Usually, flexible packaging plates have a relief thickness of about 50 % of the total plate thickness, whereas for corrugated plates the relief thickness may be between 33-50% of the total plate thickness. Thus, plates for flexible packaging have a typical relief thickness range from 0.38 to 0.85 mm, whereas corrugated plates have a typical relief thickness range between 1.2 and 2.4 mm. In view of the small relief thickness of flexo plates, the described method of creating sunken structures helps avoiding accidental printing, which may occur with a relief structure above the plate floor.

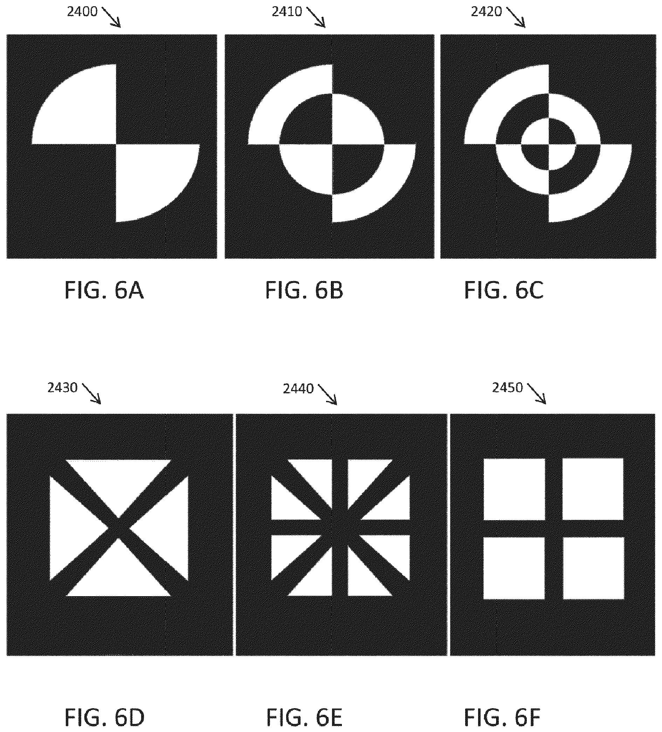

The UV light sources used for curing printing plates typically emit divergent radiation, meaning the light that enters the plate through the mask openings diverges inside the plate in the shape of cones. A longer distance for the light to travel between plate surface and floor level leads to wider cones. With greater distance between plate floor level and print surface level, the marks on the floor become less visible later when the plate is processed. The elevation of the marks from the floor level 1910 to the non-printing level 1920 is not a sharp transition but a smooth ascent causing a structure with only little contrast. Consequently, marks, letters and barcodes on corrugated plates generally need to be bigger compared to marks on flexo plates to have a similar visibility to the human eye. Thus, it is advantageous to use alignment marks that have larger solid areas instead of crosshairs having thin lines. Fig. 6A to 6F show non-limiting examples of such advantageous alignment marks 2400, 2410, 2420, 2430, 2440, and 2450.

Reproducibility of floor elevation is desirable. According to aspects of this aspect of the invention, the floor elevation is created by UV exposure of the polymer sheet through the LAMs (or a film) on the plate's front side, which will be the printing side after complete processing of the plate. The amount of UV light received determines the floor elevation of cured polymer on the PE foil. The size of the mask openings, in turn, define the amount of UV light that can enter the plate. Therefore, the precision of the mask openings directly affects the precision of the floor elevation in the plate.

While the use of approximately circular shaped patterns (i.e. microdots) to create non-printing structures on the plate are described herein above with respect to some embodiments, some embodiments may use instead microline patterns, preferably oriented in the imaging direction of the LAMs (the direction of travel of the imager relative to the LAMs layer during an imaging step). As used herein, the term "microstructures" refers to non-printing structures, which may be in the form of microdots (i.e. approximately circular) or microlines (also referred to herein as "line patterns" or "linear structures"). The term "microstructures" may also be used to refer to the mask openings that lead to the formation of microstructures on the plate, or the imaging information used by the imager to form the mask openings.

The creation of line patterns in the imaging direction requires fewer switching events of the imaging beams compared to dot patterns, wherein a "switching event" is defined as an on-off switch of the imaging beam (e.g. laser). Thus, the switching time (the time required to switch a beam from on to off, or vice versa), which affects the imaging speed, does not affect the imaging speed for linear mask openings as much as the switching time affects dot-shaped mask openings, as dot-shaped openings usually comprise clusters of several imaging pixels and require more switching events.

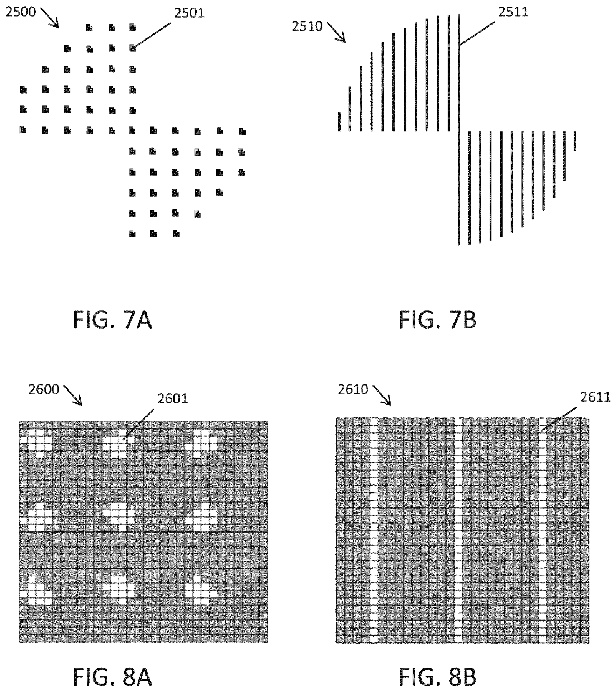

The difference is depicted in FIGS. 7A and 7B, which show the mask openings for a registration mark made from conventional pixel clusters 2501. In FIG. 7B, the same registration mark is shown with the suggested pattern of lines 2511. The total number of imaging pixels used for the mask openings is nearly identical for both alignment marks, but for the mark in FIG. 7A, many more switching events occur. As can be seen in FIG. 7B, the line pattern also offers better definition of the outline of the crosshair, because it does not depend on fixed grid positions as much as patterns based on pixel clusters do.

For dot-shaped clusters of imaging pixels, the two degrees of freedom for varying the opening of the LAMs include: the total number of pixels in the clusters; and the distance of the clusters from one another. For line shaped patterns, the equivalent for these two degrees of freedom include the width of the line and the distance between the lines.

FIG. 8A shows a screen style grid of 30 x 30 cells. Each cell represents a pixel in the image file used for ablating the LAMs. The tile comprises nine pixel-clusters 2601, each having 10 ablated pixels. Thus, 90 pixels out of the 900 of the 30 x 30 cell matrix are mask openings that allow UV light to enter the plate and cure portions of the plate floor.

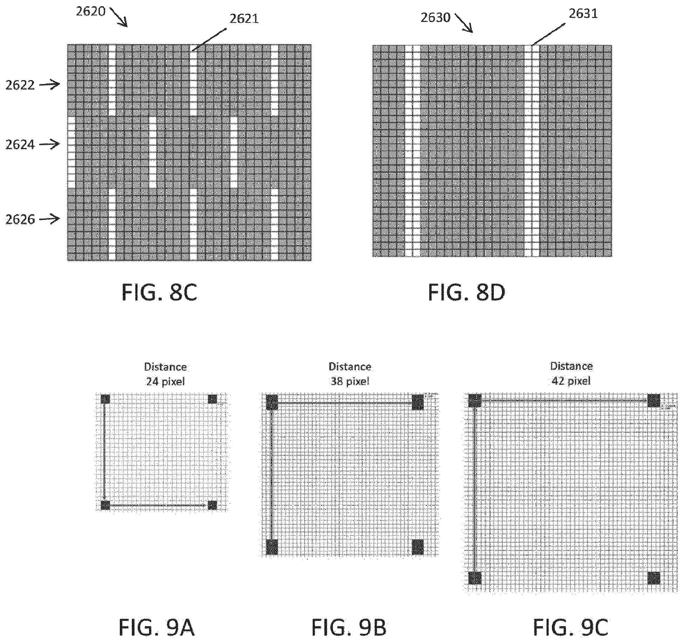

In FIGS. 8B and 8C, similar 30 x 30 cell matrices are depicted with a line pattern also comprising 90 open pixels. Thus, the amount of UV light entering the plate is in the same range as in FIG. 8A, yet the mask opening in FIG. 8B permits a faster imaging speed. The lines of these patterns are oriented parallel to the imaging direction, such that for each line only one turn on and turn off switching event of the imager is required.

FIG. 8C shows an example of a staggered variation of the line pattern, in which non-continuous line segments 2601 are arranged in rows 2622, 2624, 2626, in which the segments in each row are aligned on-center between the corresponding segments in adjacent rows (as per the relationship depicted for the segments in row 2624 relative to the segments in 2622, 2624, and vice versa). FIG. 8D shows an example of increased line width. Patterns are not limited to the examples depicted in FIGS. 8A-D, and other pattern configurations may be used for plate floor creation.

It should be understood that, for illustrative purposes, the distances of the details in FIGS. 8A-D are smaller than for patterns employed in a typical commercial application. For example, in an application having a 4000 DPI image resolution, the distance between mask openings for making the subject indicia (e.g. registration mark 2510) may be in a range between 20 and 60 pixels. Exemplary pattern distances (e.g. 24, 38, and 42 pixels, respectively) employed in a commercial embodiment used in tests are depicted in FIGS. 9A-C. In general, when forming object-oriented patterns, the size of the object determines the properties of the mask openings (number of pixels in a pixel cluster, distance between the pixel clusters). Smaller objects generally have more mask opening per surface area (pixel clusters comprising more pixels and being located closer together), whereas larger objects can be grown with fewer mask openings per surface area (pixel clusters comprising lesser pixels and being located further apart).

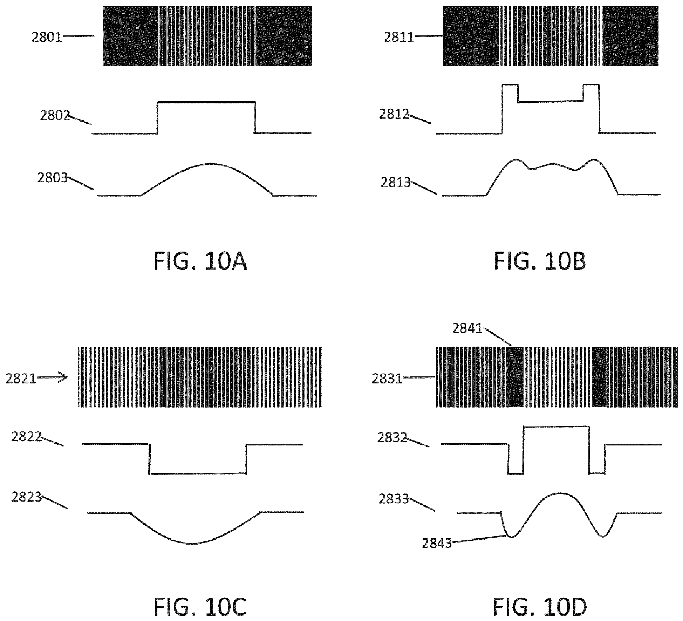

In another aspect of this invention, the contrast between the floor level and another elevation level for a non-printing object on the floor may be increased by enhancing the change of light transmissibility of the mask openings at the boundary between the floor and an elevated object. This is depicted in FIGS. 10A and 10B. Details 2801 and 2811 each show a stripe of LAMs with a line pattern for a non-printing mask opening. The LAMs layer is depicted in black, and removed areas are depicted in white.

Details 2802, 2812 show the relative intensity profile of the UV light that enters the plate through the mask openings. Details 2803, 2813 show the principle shape of the resulting non-printing structure on the plate floor. FIG. 10A shows a conventional mask opening area as it would be used on a plate where the floor is exposed from the plate's rear side. The mask opening area in Fig.10B has wider line openings in the mask at the transitions to the non-ablated mask areas. These wider openings cause the non-printing structures to grow stronger at the edges, which makes them steeper and visually more recognizable.

FIGS. 10C and 10D depict exemplary sunken structures formed when the floor thickness or at least a part of the floor thickness is created by exposure from the plate's front side. FIG. 10C shows the creation of a simple sunken structure 2823 by reducing the light transmissibility on a part of the mask, per the mask openings in detail 2821 and resulting transmitted light intensity 2822. In FIG. 10D the contrast of such an elevated structure 2833 is increased by the use of additional non-transmissive areas 2841 in the mask 2831 that correspond to sunken edges 2843 of the elevated structure. Although shown in FIGS. 10A-D formed with line patterns, it should be understood that dot patterns may also be used to form similar structures.

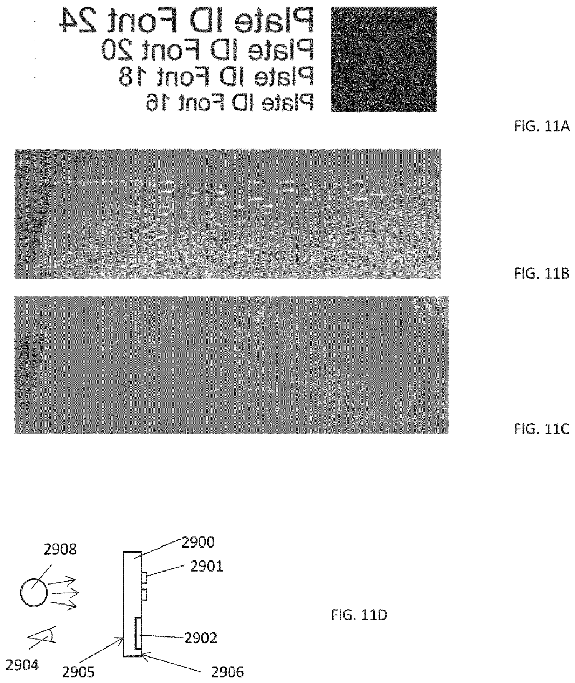

Non-printing details, whether higher or lower than the plate floor, will be more visible to human eye when the plate is viewed from the back side and at the same time illuminated from the viewing side by a light source. In particular, smaller alphanumeric signs may be recognized more clearly, as is illustrated by comparing the photograph as depicted in FIG. 11B to that depicted in FIG. 1C, both comprising images of the non-printing indicia depicted in FIG. 11A, embodied on a plate. Recognition of the plate may be improved when the non-printing information in form of alphanumeric signs is implemented in mirrored orientation such that the information is readable to human operators when viewed from the back side of the plate, thus making it easier for human operators to more readily identify stored plates intended for a second print run. Accordingly, in preferred embodiment, as depicted in FIG. 11D, alphanumeric non-printing indicia 2902 may be oriented to be readable when viewed by a viewer 2904 (depicted as a human eye, but the viewer may include a camera) from a back side 2905 of the plate 2900 (i.e. in mirror-image from the front side 2906 of the plate containing printing structures 2901) and methods of using the indicia may include illuminating the area of the plate containing the indicia from at least the viewing side, such as with source 2908.

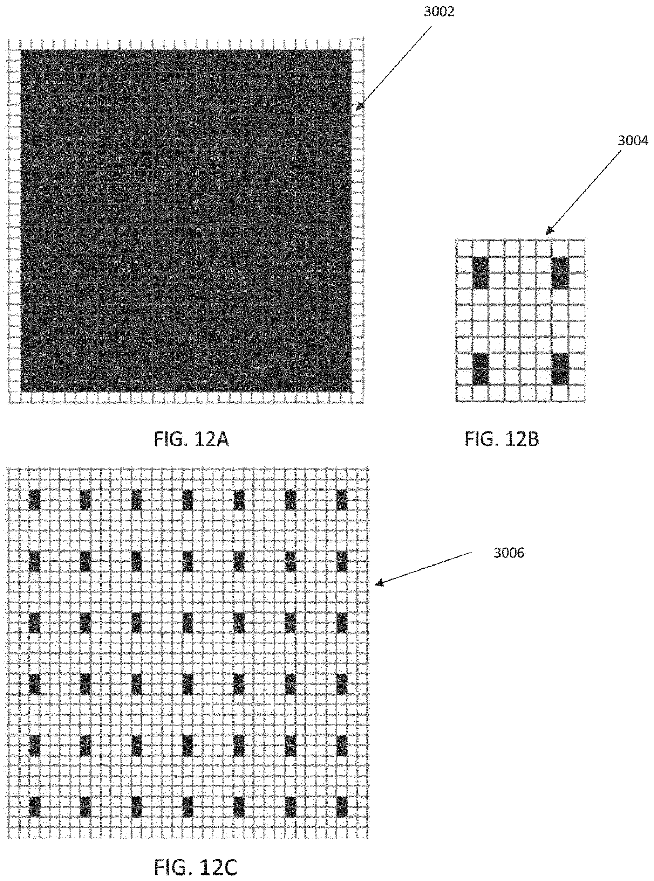

The foregoing methods as described herein may be used in conjunction with any type of photopolymer cured by any type of actinic radiation, and processed after the radiation exposure step in any type of process for removing uncured polymer, including but not limited to a thermal, solvent or water-based process. Additional finishing or detacking steps may be performed, as are known in the art. Another embodiment for providing alignment marks is illustrated in FIGS. 12A-14. In this embodiment, small, isolated non-printing micro alignment marks for plate positioning are formed a flexographic printing plate. These micro alignment marks may be used, for example, to detect the image position on a cutting table or to align plate patches on a printing cylinder.

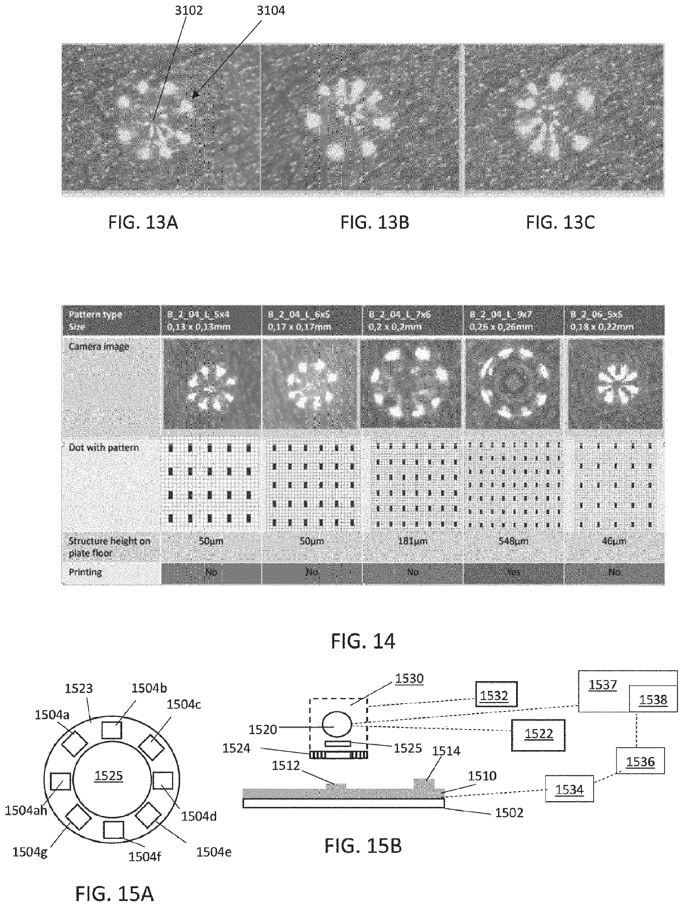

Historically, such non-printing position marks have been either sufficiently precise but too small to be visible to a human operator for determining a position, or sufficiently visible for the human operator, but too large to define the position with adequate precision. It has been found that a small, non-printing micro alignment mark 3102 as depicted in FIG. 13A can be readily detected by a human operator when the micro alignment mark is illuminated by a ring of LED light sources 1524. As long as the LED ring is concentric with the position of the micro alignment mark as is depicted in FIG. 13A, the reflex of the LEDs on the dots shoulders is perfectly circular. As soon as the centre of the LED ring and the centre of the dot are not aligned, such as is depicted in FIGS. 13B and 13C, the light-reflex is not circular anymore. By using this effect, the plate can be positioned with high accuracy.

In the example depicted in FIGS. 13A-15C, micro alignment mark 3102 has a 130 $\mu$m diameter and a height of 50 $\mu$m, and was found to provide location accuracy within 40 $\mu$m. The invention is not limited to any particular size. An exemplary process for creating such a micro alignment mark includes applying a microstructure dot pattern, such as pattern 3004 depicted in FIG. 12B, to an exemplary dot 3002, depicted in FIG. 12A, to yield a patterned micro alignment mark 3006 as shown in FIG. 12C. As depicted in FIG. 14A, dot 3000 has an area of 31 x 31 pixels, which at 4000 dots per inch, is sized at approximately 20 $\mu$m. The pattern has a solid area of 2 "on" pixels separated by 4 "off" pixels between adjacent "on" pixels, with a pattern repeat of 7 pixels in the horizontal direction and 6 pixels in the vertical direction over the relevant 31x31 pixel area. An exemplary nomenclature for expressing this pattern may be expressed B_2_04_L_7x6, with the last two numbers ("7x6") indicating the number of pixel clusters repeated in the horizontal and vertical directions, respectively. In the examples shown, a Flint NEF 045 (1.14 mm) plate was used, having a solid thickness of 1.14mm, floor thickness of 0.59 mm, and a relief of 0.55 mm). The workflow included an Esko CDI Crystal 4835 Optics 80 V2 imager, an Esko Crystal XPS 4835 UV exposure unit, and the plate was developed using a solvent washing process.

As depicted, the LED ring is comprised of 8 LEDs, but the invention is not limited to any particular number of LEDs. One or more optics 1525 (e.g. magnifying optics, such as a microscope, filters, etc.) may be used for enhancing visibility of the characteristic pattern to the viewer. Typically, a camera may be used for viewing the alignment of the dot within the LED ring, but the characteristic pattern may also be viewed by a human viewer by the naked eye or through one or more optics. The table depicted in FIG. 14 shows the results of various patterns applied to 20 $\mu$m dots, with pattern sizes expressed in the nomenclature as described above. The table also shows the height of the resulting dot, an indication of whether the dot printed or not, and an image corresponding to the dot centred within an exemplary LED light ring. Although not limited to any particular size dot or pattern for creating the dot, the examples show that a wide range of patterns that may be used to create suitable dots.

Thus, aspects of this embodiment of the invention include processes for making alignment micro alignment marks as described, plates including the same, and workstations for receiving plates in a preferred alignment, wherein the systems include an LED ring 1524 in a location for illuminating a micro alignment mark as described herein. FIG. 15A depicts an exemplary ring 1524 comprising eight LEDs 1504a-h disposed on substrate 1523, and optional optics 1525 centred relative thereto. FIG. 15B, depicts a printing plate 1510 having an isolated micro alignment mark 1512 and printing structures 1514 thereon. Illumination from ring 1524 of LEDs 1504a-h are characteristically reflected by the micro alignment mark 1512 and visible to a viewer 1520 disposed above the plate. Viewer 1520 may be a camera (or other image capture device) or a human viewer. In embodiments in which viewer 1520 is an image capture device, the image capture device may be connected to a display 1522 configured to display the image for viewing by a human viewer and/or the camera may be a component of a machine vision system 1537 that further comprises a processor 1538 programmed with appropriate algorithms for processing images captured by an image capture device. The viewer, camera, or display observes from above the plate for the characteristic illumination of the micro alignment mark by the ring of LEDs (e.g. as depicted in FIG. 13A or any of the images depicted in the table of FIG. 14) when the plate is aligned on the substrate with the isolated micro alignment mark in a desired location centered relative to the LED ring. "Centered relative to the LED ring" means that a center of the micro alignment mark is aligned relative to a central axis perpendicular to the printing plate defined by the LED ring within a desired degree of tolerance. Notably, the mark identified in FIG. 14 as printing, while generating the same characteristic illumination, is disfavored because it prints. Substrate 1502 may be any substrate for receiving a plate in a printing or pre-printing process workstation, including but not limited to a cutting table, a mounting unit for mounting a plate portion on a substrate, or a drum or other surface for aligning a plate for a printing step, without limitation.

The ring of LEDs may be disposed on a camera system having an alignment system in which a positioner 1530 controlled by a positioning controller 1532 associated with the camera system positions the camera at a predetermined coordinate and the plate is moved into a position in which the micro alignment mark is centered relative to the LED ring as determined by the characteristic illumination observed on the display. Camera systems and positioning systems are known in the art, and any structure for adding a ring of LEDs thereto may be implemented. Ideally, the ring of LEDs does not obstruct the field of vision of the camera system, but rather only provides illumination. The ring of LEDs may be controllable to turn on or off, by a user or by a machine when in use for alignment. A determination of alignment may be made by a human viewer observing the image on the display, or automatically using machine vision system 1537. The means 1524 for adjusting the position of the plate or plate portion bearing the micro alignment mark until it is disposed in the desired alignment position may comprise a human operator or a machine, such as an arm of a robotic handling system, and a machine positioner may be interactively controlled by a human or by a machine. A human operator controlling position of the plate (directly or via control of a machine positioner) may stop adjusting the plate position once the human operator detects the characteristic illumination on the display 1522. A machine positioner may be controlled by a controller 1526 programmed to stop adjustment of the plate upon receipt of a signal from the machine vision system 1537 that the plate is aligned. The plate positioner may move the plate relative to a substrate 1502 on which the plate is disposed, move the entire substrate 1502 relative to the LED ring, or a combination thereof.

Thus, an exemplary method for orienting a plate relative to a workstation (e.g. on a substrate), may include providing a ring of LEDs disposed above a surface of the plate, illuminating the ring of LEDs, and placing a plate as described herein having an isolated micro alignment mark on the substrate while observing light reflected by the plate from the illuminated ring of LEDs, such as using a camera viewing the reflection through optional optics. A user may adjust the location of the plate until the characteristic illumination pattern of the micro alignment mark by the ring of illuminated LEDs is observed that signifies that the micro alignment mark is centered relative to the LED ring. In a subsequent alignment step, the LED ring and associated camera and/or optics will be positioned at another defined location where a second mark of the plate must be centered. Although certain aspects of the invention are particularly useful and advantageous in a flexo environment, the disclosure herein is not limited to any particular type of plate or processing.

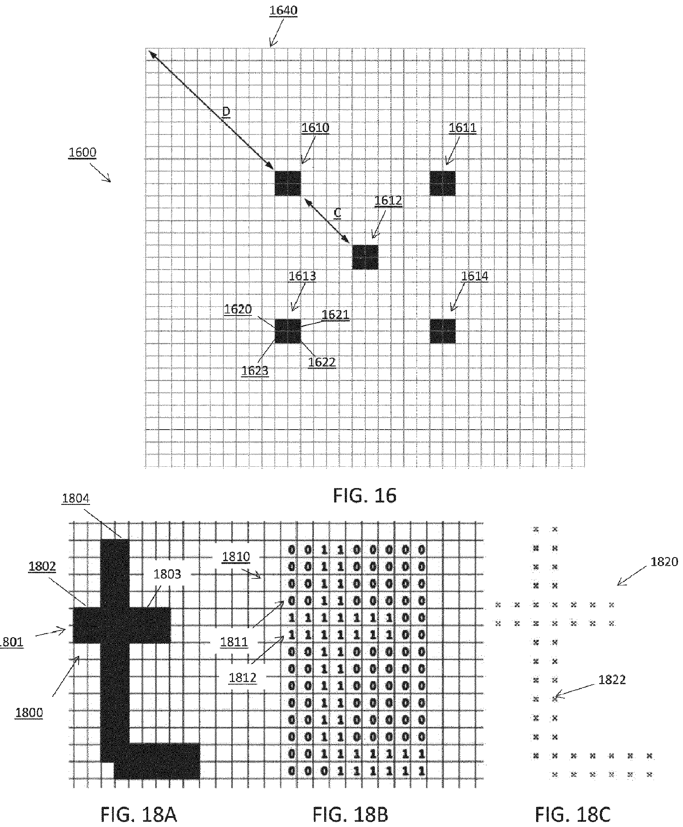

As mentioned above, e.g., with respect to FIG. 11A, non-printing indicia may be formed above or below the plate floor, such as in the form of characters or codes readable by a human operator or machine vision system, and these characters or codes may be formed using micro dots. However, superimposing a homogenous pattern of micro dots on at least some types of characters may result in different elevation levels in different portions of the character. For example, referring now to the alphanumeric character 1800 depicted FIG. 18A (the letter "t"), if the character were formed using a homogenous pattern of microdots, the area where the cross bar 1801 intersects the ascender 1804 may have a higher elevation than the arm 1803 and beak 1802 of the crossbar and the remaining portions of the ascender above and below the crossbar. This effect may be avoided if the letter is instead assembled from several supercell-clusters of microdot clusters, such as the supercell 1600 depicted in FIG. 16, which creates a small elevated spot on the floor. The supercell is defined by four parameters A, B, C, and D, which may be used in a descriptive nomenclature A_B_C_D to refer to its properties:

"A" corresponds to the number of microdot clusters. Supercell 1600 comprises five microdot clusters 1610-1614 arranged like the five "eyes" on cubic casino dice, with a central microdot cluster 1612 and four outer microdot clusters 1610, 1611, 1613, and 1614, spaced diagonally from the central microdot cluster.

"B" corresponds to the number of pixels that build one microdot cluster. Each microdot cluster (e.g. cluster 1613) comprises four "on" pixels 1620-1623, each of which corresponds to a mask opening in a mask and ultimately to an exposed pixel on a plate. Although depicted with four pixels forming each microdot, other numbers of pixels may be used.

"C" corresponds to the diagonal distance in unexposed or "off" pixels between the microdot clusters (e.g. measured from the corners of the central cluster 1612 to each of the innermost corners of the outer clusters 1610, 1611, 1613, 1614). C=4 for supercell 1600.

"D" corresponds to the diagonal width of the "padding" of the supercell not containing any exposed pixels between the boundary 1640 of the supercell and the outermost edge of the outer microdot clusters (e.g. measured from the outermost corner of each of the outer pixel clusters to a corner of the supercell boundary). D=10 for supercell 1600.

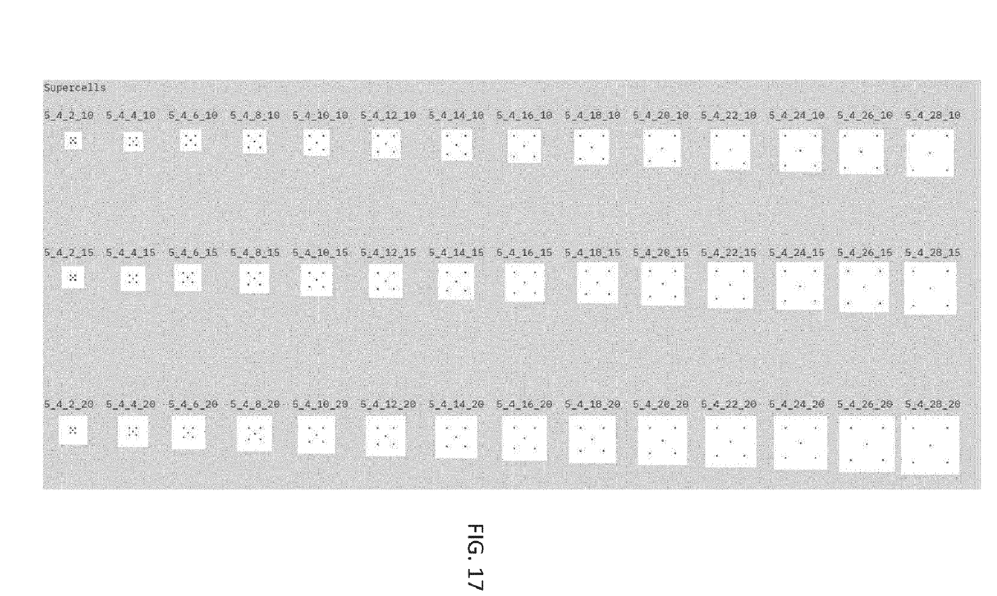

Thus, supercell 1600 may be defined using the foregoing nomenclature as a 5_4_4_10 supercell. FIG. 17 provides an overview of different possible supercell dimensions that can be applied to different types or thickness of polymer plates, identified using the foregoing nomenclature. Although depicted as 5-cluster, 4-pixel supercells, supercells comprising different numbers (e.g. 3, 4, 6) of microdot clusters and clusters comprising different numbers of pixels per cluster (e.g. 2, 3, 6) may also be used, without limitation. Although depicted with square pixels, the geometry of the pixels is not limited to any particular shape.

The elevated spots on the floor formed by each supercell may be arranged in lines and rows that form alphanumeric characters or codes with a constant elevation level. Due to the padding around the microdot clusters, the supercells avoid amplification from neighboring supercells that may otherwise form higher elevation levels if formed using different structures. Independently from the number and arrangement of supercells that form the indicia, the elevation level may thus be relatively constant for each dot formed by a supercell. FIGS. 18A-C depicts the translation of a letter "t" 1800 in FIG. 18A to a digital set 1810 of "on" ("1") pixels 1812 and "off" ("0") pixels 1811 in FIG. 18B to the arrangement 1820 of supercells 1822 corresponding to the "on" pixels in FIG. 18C, in accordance with the described method.

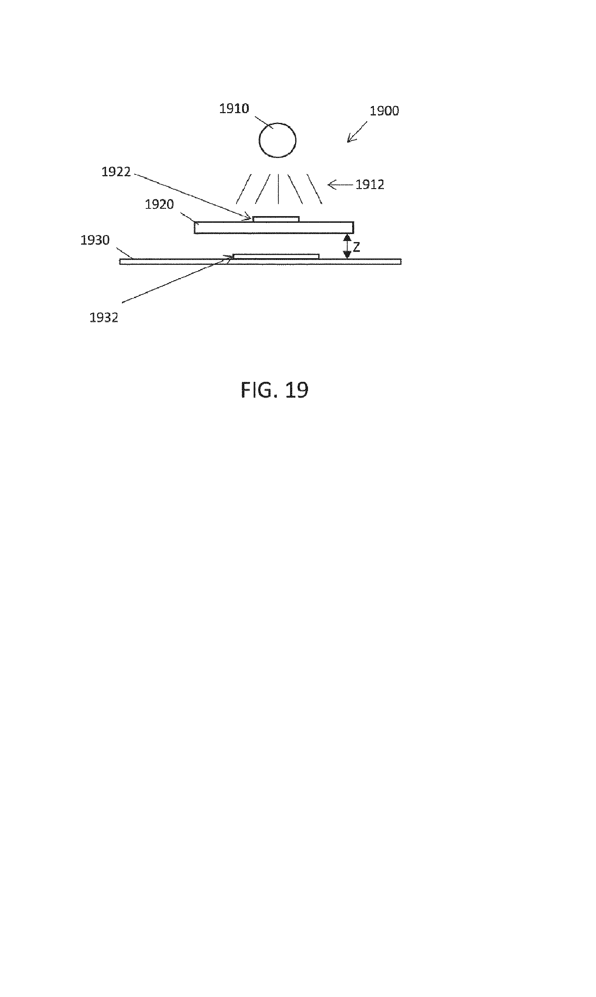

Referring now to arrangement 1900 depicted in FIG. 19, it has also been observed that indicia formed by dots 1922 disposed on plate 1920 define micro lenses capable of focusing light 1912 from a source 1910 located above the printing side of the plate to form a projected image 1932 on an opaque surface 1930 spaced a distance Z (e.g. 2-8 mm) from the back side of the plate. Thus, unlike the arrangement depicted in FIG. 11D, wherein alphanumeric characters viewed directly from the back of the plate will be a mirror image of the indicia as viewed from the front of the plate, the characters as viewed on the surface 1930 will be in the same orientation (but magnified) as the indicia as viewed from the front of the plate. Notably, although FIG. 19 depicts the projected image 1932 in side view as having a height above the surface, this is for illustration only, as the image will be disposed on the (e.g. plane) defined by the surface, not above the surface, as will be well understood by one of skill in the art.

## IMPROVED READABILITY

The foregoing describes a modification to non-printed indicia that converts the inter-connected pattern structures into individual dots on the plate floor, which dots, when illuminated from the plate's printing side, give a clearly recognizable spot pattern of reflected light. The combination of all reflecting dots creates a pattern akin to zodiacal signs that can be easily recognized and decoded. The patterns can also be conceptualized as being akin to braille letters.

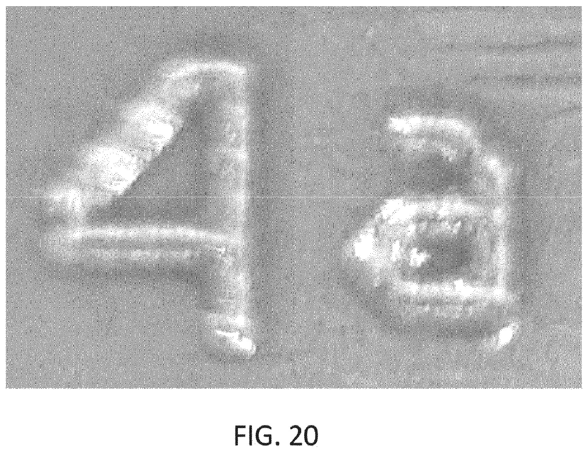

FIG. 20 shows exemplary non-printing features of some of the earlier approaches described in the background section, which result in non-printing indicia that define solid interrelated structures. These structures may need to be illuminated from optimal directions to recognize them clearly.

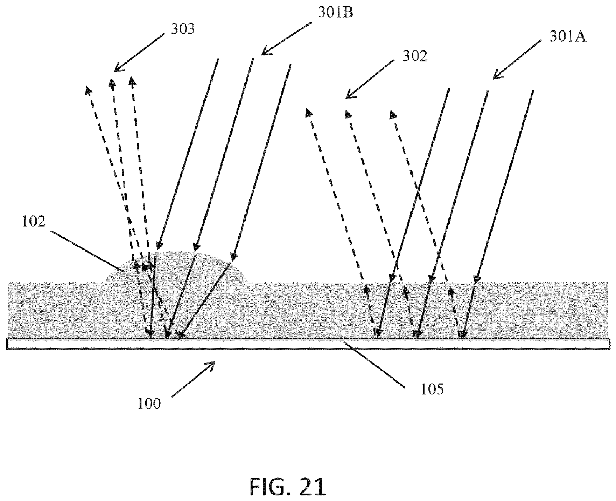

However, such non-printing features have improved visibility when formed from single microdots instead of solid interrelated structures. As described above, and as depicted in FIG. 21, without being tied to any particular theory of operation, it is believed that these non-printing microdots on the plate floor function as a lens that concentrates light rays 301B, which propagate towards the top side of the polymer plate 100. For incoming light rays 301A on the right side of FIG. 21, the non-structured plate floor acts like a mirror and reflected light rays leave the plate without being substantially altered in their common direction. By contrast, incoming light rays on the left side are concentrated by the non-printing polymer dot 102 on the other side of the plate floor on the dimensionally stable foil 105. Here the reflected rays that leave the plate have altered angular relationships.

Scattering effects may also play a role, but the claimed invention is not limited to any particular physical mechanism for producing the observed effects relating to the claimed apparatus, systems, and/or methods. Those observed effects include a boundary behavior (e.g. transmission, reflection, and/or refraction) of radiation (e.g. light) applied to the isolated dots that is detectably different than the boundary behavior of the same radiation applied at a same angle on an area of the plate floor not having such an isolated dot.

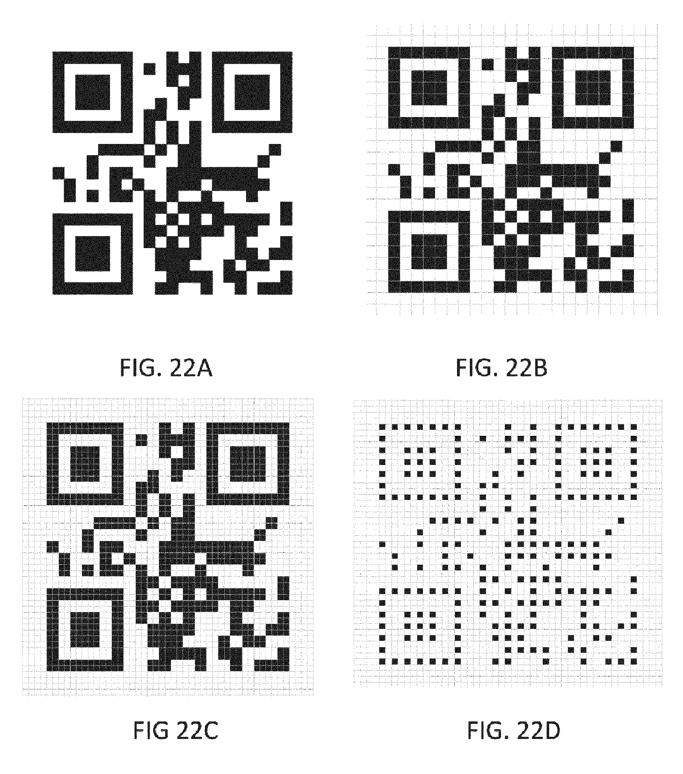

FIG. 22A depicts a schematic example of a 21 x 21 matrix QR-code, equivalent to a 441-bit code, made from interrelated structures. Black areas in the drawing represent elevated structures, whereas white areas represent the floor level of the plate. FIG. 22B depicts a schematic example of the same QR-code of FIG. 22A, but with a visible grid that determines the possible positions of the elevated and non-elevated structures that embody the code. These positions are akin to pixels or bits of the code. FIG. 22B shows the same code and grid of FIG. 22B, but with the resolution of the grid doubled. FIG. 22D depicts the same QR code of FIGS. 22A-C with elevated details deleted in every other row and column (e.g. every odd-numbered row and column or every even-numbered row and column, sequentially numbering each row and column from one corner of the grid). This operation turns all connected details or pixels of the previous code pattern into a pattern of single individual dots. Each of these dots represents the positions of an elevated dot on the plate floor.

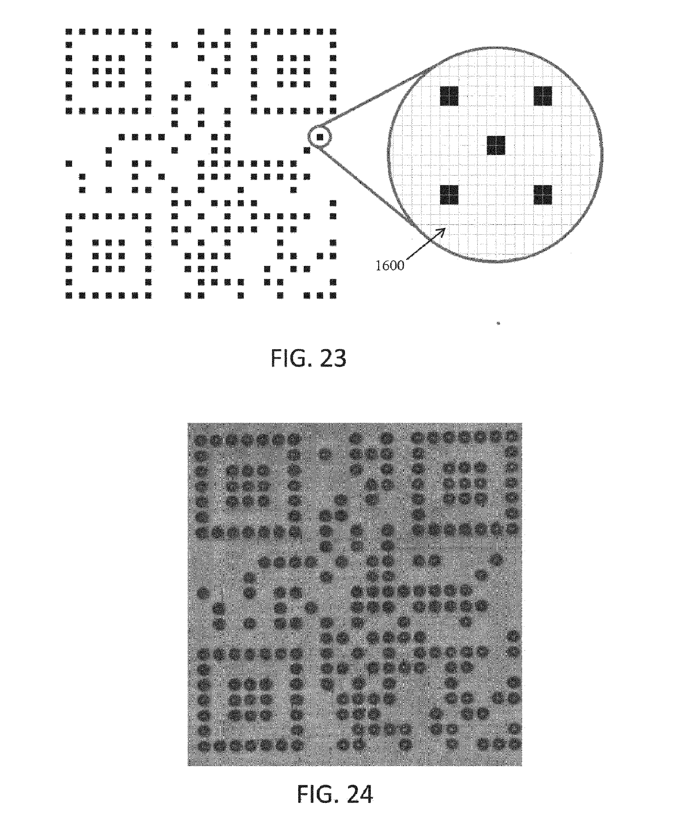

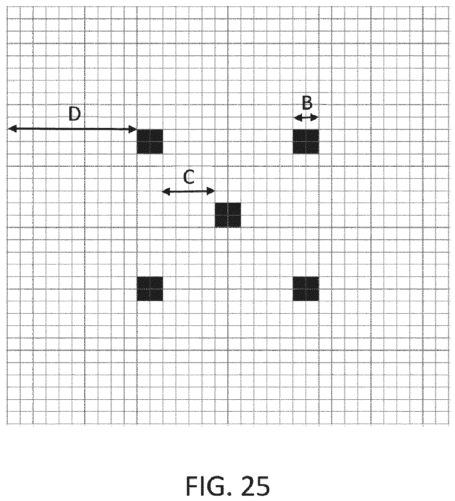

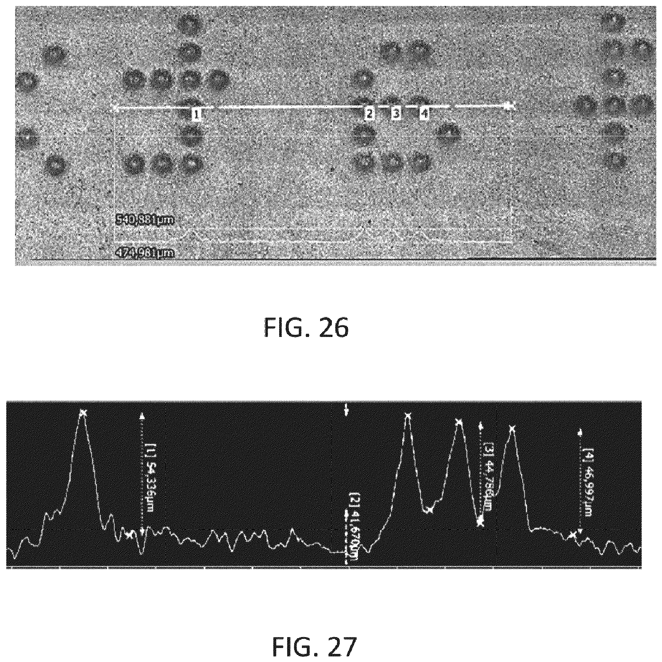

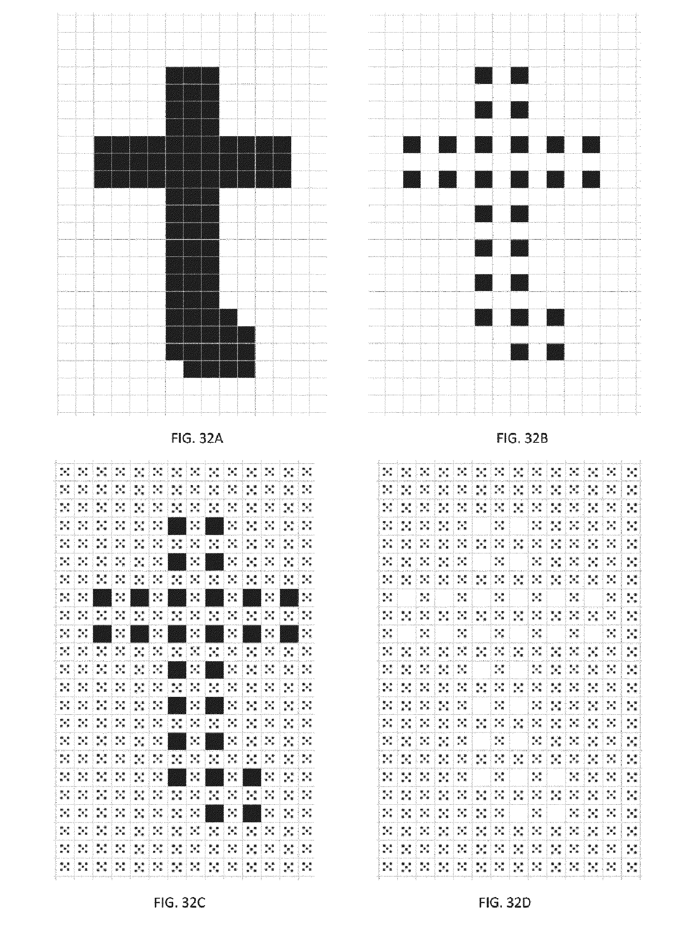

FIG. 23 depicts the exemplary code in which each individual dot of the code pattern is replaced by a matrix of image file pixel clusters, arranged in the supercell pattern 1600 depicted in FIG. 16. FIG. 24 shows a photograph of the resulting, non-printing QR code pattern of FIG. 23 as formed on the floor of a DPR 045 plate. Fig. 25 shows the mask opening pixels of a supercell with respect to their position on the image file grid, with dimensions B, C, and D as described herein later. FIGS. 27 shows the result of a depth analysis using a confocal microscope of the microdots depicted in FIG. 26 on a DPR 045 Plate.

Maintaining a preferred distance between the supercell positions in the mask grows individual dots without building the interconnected structures such as those depicted in Fig. 20. The distance between the supercells is dependent on the type of polymer, the plate thickness, and the properties of the UV exposure radiation, including but not limited to irradiance, angular distribution of the propagating light rays, and wavelength composition of the light. Typically, the floor level is at a level of 50% of the cured plate thickness measured from the plate's non-printing back side while the non-printing elevated structures preferably do not exceed 20% of the total plate thickness above the floor in order to avoid printing.

Exemplary measured elevation levels for the dot structures on a DPR 045 Plate between 40 and 55 $\mu$m are depicted in FIGS. 26 and 27. The elevation level depends on boundary conditions such as plate type, exposure parameters, and the pattern of pixel clusters in the mask. In general, elevation levels of the individual dots preferably range between 30 and 100 $\mu$m, more preferably between 40 and 80 $\mu$m. In addition to improved visibility, another advantage of using isolated dot structures rather than interconnected structures, is that the dot structures have an overall lower elevation level. Minimizing height of the non-printing indicia structures above the plate floor is beneficial, because the less distance between the printing top surface and the tips of the highest non-printing structure elevations on the floor, the more likely the non-printing structures may experience undesired inking. The lower elevation provided by the isolated dot structures as described herein also greatly reduces the likeliness of unwanted printing as compared to other methods.

The desired distance from the printing height and the size of the individual dots limit the number of dots per surface unit, which in turn also limits the amount of information that can be stored in a code on the plate floor. This limitation can be expressed in the number of dots respectively addressable using the unit measure "Bits per cm$^2$." For a common DRP 045 Plate developed under typical state of the art conditions, this parameter is approximately 80 Bit/cm$^2$. Therefore, exemplary calculations for creating non-printing codes or alphanumeric signs for the non-printing image file start with the size requirements of the supercell in the light of the plate type and exposure unit. To make these calculations simple it is advantageous to have a library of supercells available for a given UV exposure system and various plate types and plate thickness.

An exemplary library for supercells such as depicted in FIG. 25 contain characterizing information about the supercell types. Each supercell has a first number A of exposed pixel clusters, each exposed pixel cluster comprising a second number B of exposed pixels, the exposed pixel clusters are spaced apart from one another by a third number C of unexposed pixels, and finally a padding between the boundary of the supercell and a closest exposed pixel cluster is defined by a fourth number D of unexposed pixels. Notably, A, BAs depicted in FIG. 25, the black pixels represent mask openings while white pixels stand for absence of mask openings. TABLE 1 below gives some examples from an exemplary library of different supercell types for different plate types and for 4000 DPI image file resolution.

TABLE 1

| Plate type | Plate thickness [mm] | Supercell type [A B C D] | Distance C btw. Clusters [pixel] | Type 1 Supercell size [pixel x pixel] | Type 2 Supercell Size [pixel x pixel] | Avg.# Type 2 dots per surface area [dots/cm$^2$] |
|---|---|---|---|---|---|---|
| DPR 045 | 1.14 | 5_4_20_20 | 20 | 86 x 86 | 172 x 172 | 83 |
| ACE 045 | 1.14 | 5_4_20_20 | 20 | 86 x 86 | 172 x 172 | 83 |
| ACE 067 | 1.70 | 5_4_16_20 | 16 | 78 x 78 | 156 x 156 | 101 |
| FTF 045 | 1.14 | 5_4_14_20 | 14 | 74 x 74 | 148 x 148 | 113 |
| FTF 067 | 1.14 | 5_4_28_20 | 28 | 102 x 102 | 204 x 204 | 59 |
| ITP60 045 | 1.14 | 5_4_26_20 | 26 | 98 x 98 | 196 x196 | 64 |
| ITP60 067 | 1.14 | 5_4_28_20 | 28 | 102 x 102 | 204 x 204 | 59 |
| DSF 112 | 2.84 | 5_4_16_20 | 16 | 78 x 78 | 156 x 156 | 101 |

The number of pixels of the supercells in one dimension can be calculated by Formula (1), below:

$$3 \times B/2 + 2 \times C + 2 \times D \qquad (1)$$

This resulting size of the pixel is the absolute dimensions of the supercell in one direction. For example, the first supercell in TABLE 1 has a size of 86 x 86 pixels of the image file resolution.

In some cases, B/2 is not the exact value because the pixel cluster might have a different number of pixels in horizontal direction compared to the number of pixels in vertical direction. In this case adjustments must be made according to the shape of the pixel cluster.

As the image file resolution in TABLE 1 is 4000 DPI, each pixel has 6.35 $\mu$m in the lateral direction, so the calculated lateral dimensions of the supercell for the DPR 045 in FIG. 1 is equivalent to 0.5461 x 0.5461 mm$^2$ in accordance with Formula 1.

The information in TABLE 1 referring to supercells that will create interconnected structures is contained in the column titled "Type 1 Supercell size" and such supercells are referred to herein below as Type 1 supercells. To obtain individual, separated dots on the plate floor instead of interconnected structures, an additional padding of 0.5 times the length of the Type 1 supercell must be added on each side of the supercell. This quadruples the size of the supercell. The supercell with additional padding will be called a Type 2 supercell herein below. Therefore, the space needed for a single Type 2 supercell corresponding to the Type 1 supercell referenced in TABLE 1 is increased to 1.0922 x 1.0922 mm$^2$. Thus, the resulting dimension of a 21 X 21 Bit wide QR code as depicted in FIG. 24 on a DPR 045 Plate @ 4000 DPI image file resolution is about 22.9 x 22.9 mm, with the number of elevated dots that can be placed within one cm$^2$ being approximately 83.

It should be understood the number of addressable information in such a non-printing QR code structures may be further reduced by the syntax conventions of the particular code. For instance, with respect to a QR code, such syntax conventions may include the level of error correction, format information, and/or locator marks.

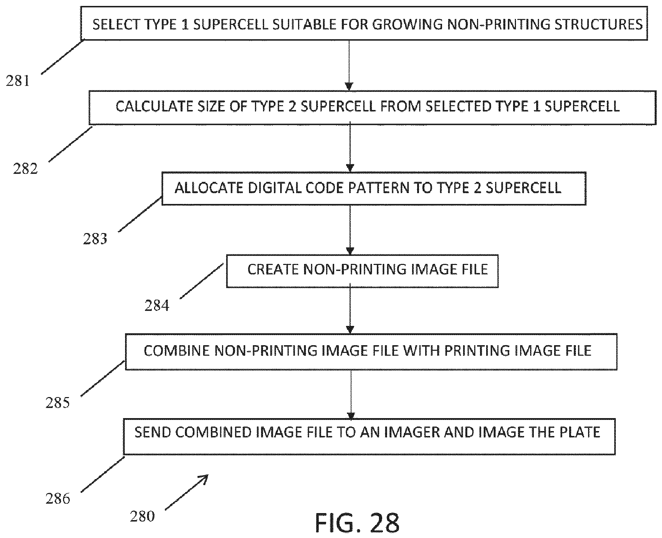

An exemplary method of implementing patterns of non-printing code on the plate floor includes the steps outlined in flowchart 280 depicted schematically in FIG. 28. The method includes in step 281, selecting from a library a Type 1 supercell containing a pattern of mask openings suitable for growing non-printing structures on the plate to be produced. In step 282, the size of the Type 2 supercell is calculated from the dimension of the selected Type 1 supercell. In step 283, the bits of a digital code pattern are allocated to a matrix of individual cells that are equivalent to the size of the calculated Type 2 supercell. In step 284, a non-printing image file is created for imaging the mask by combining the bit information of the digital code pattern with the pixel clusters of the Type 2 supercell in order to cure the photopolymer plate. In step 285, the non-printing image file comprising the digital code pattern supercell is combined with another image file comprising image information of the content to be printed, optionally (preferably but not necessarily) in a way that the elevated content of the non-printing image is located in the non-printing areas of the printing image. In step 286, the combined image file is sent to an imager and the photopolymer plate is imaged. It should be understood that the size of the Type 2 supercell may be precalculated from suitable Type 1 supercells, such that the method does not need to include a specific calculation step.

When implementing alphanumeric signs or brand logos, the image file resolution is typically matched to the grid determined by the size of the Type 2 supercell. In some cases, fine tuning can be made by adjusting the thickness of the padding around the Type 1 supercell. In any case, it may be feasible to increase the padding and therefore the distance between the centers of adjacent supercells by a factor of 0.5 (half) the Type 1 supercell dimension. In some cases, it may be possible to work with a slightly smaller increase of the padding without creating interconnected surface structures. Due to the large number of photopolymer plate types, making a general prediction as to how much closer the centre of the supercells can be placed may be risky, so it is preferred to increase padding by at least the factor of 0.5 times the Type 1 supercell.

As already known in the art, the plate floor can also be exposed through the mask in a way that sunken structures are formed. Thus, all features described in this document can also be realized in a reverse way as sunken instead of elevated dots, or as a combination of sunken and elevated dots. To create sunken dots, a grid of Type 1 supercells may be combined in a disjunction step with the image file containing the printing details. This creates an elevated floor in the UV curing step in all portions of the plate that do not comprise printing details. In an exemplary "NAND" (NOT AND) disjunction step, to create sunken dots, some individual Type 1 supercells are turned off at the places where sunken dots are needed in accordance with the image file of the non-printing details.

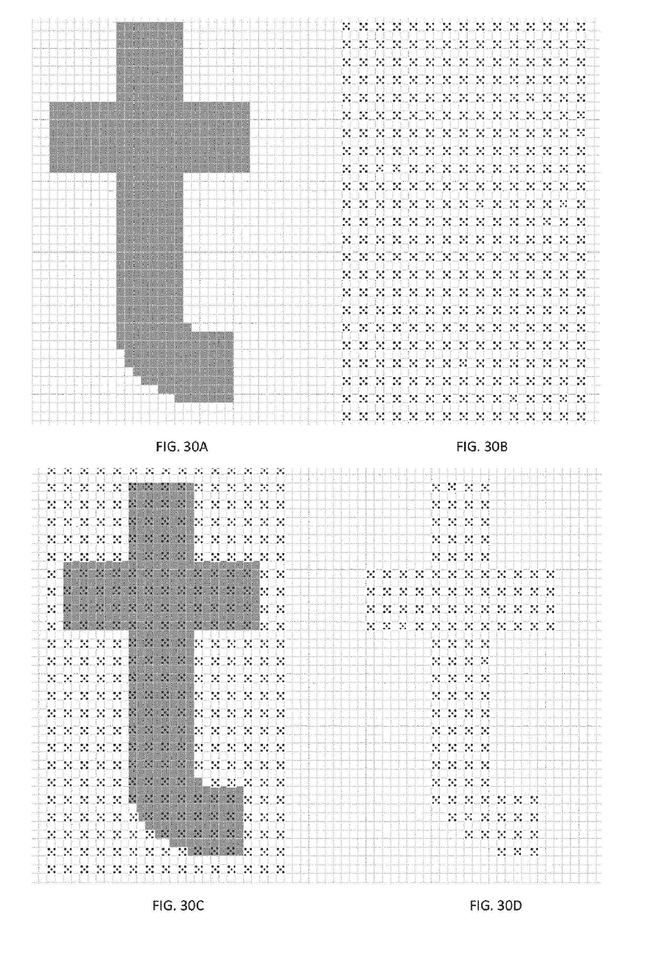

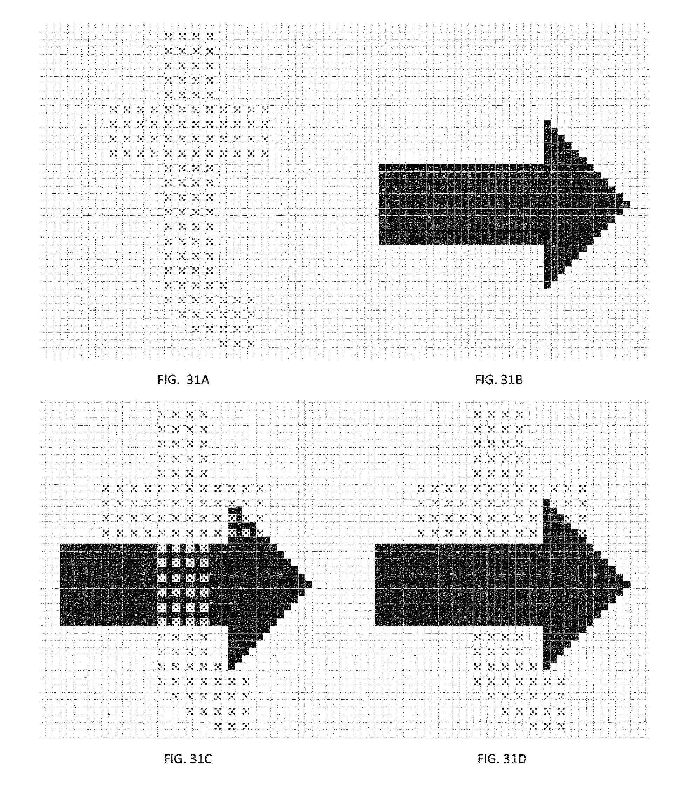

Exemplary conjunction (AND) and disjunction (OR) operations are illustrated in FIGS. 30A-30D and 31A-31D, in which black pixels correspond to openings to be formed in the mask. FIG. 30A depicts an image file corresponding to a non-printing lowercase letter "t" and FIG. 30B depicts a matrix of supercells (depicted as Type 2 but may be Type 1). FIG. 30C shows FIGS. 30A and 30B superimposed on one another at desired positions, with FIG. 30D showing a resulting image file formed by a logical conjunction operation, in which only the supercells that overlap with the non-printing image information (i.e. in the form of the letter "t") remain. In short, the resulting pixels are imaged only if they are found in both the non-printing image information (e.g. FIG. 30A) AND in the matrix of supercells (e.g. 30B).

A disjunction operation is used to combine regular printing image details with non-printing image information of the supercell patterns derived from a conjunction operation. For example, FIG. 31A illustrates a non-printing image represented by non-printing supercells as described herein (i.e. identical to FIG. 30D, as produced by the conjunction operation). FIG. 31B illustrates a printing image in the form of an arrow. FIG. 31C illustrates the superimposition of 31A and 31B, and FIG. 31D shows the resulting image information as imaged on the mask. The disjunction step may be performed in an image file when executed in a computer or it may be directly executed on the LAMs layer by sequentially imaging both image files (printing and non-printing) onto the same plate. The resulting pixels are imaged if they are found in either one the non-printing image information (e.g. FIG. 31A) OR the printing image information (e.g. 31B). An example of a method for forming sunken structures by turning off selected supercells is illustrated in FIGS. 32A-32D. FIG. 32A depicts a lowercase letter "t" to be represented in non-printing characters. In a first step, the letter "t" is converted into a "dotted" shape (i.e. every alternate pixel is turned "off") in FIG. 32B, and the "dotted "t" is then overlaid over the Type 1 supercell matrix depicted in FIG. 32C. FIG. 32D illustrates the resulting supercell matrix from a step in which each "positive" supercell corresponding to the "dotted t" turns "off" the entire Type 1 cell on which it is overlaid. This can be considered a "disjunctive" NAND (NOT AND) step in which the pixels as contained in FIG. 32B or 32C are both turned off if the dot AND the Type 1 supercell are overlapping when the files are superimposed.

Although discussed primarily above with respect to alphanumeric signs or digital codes (e.g. QR codes, barcodes, or other machine-readable 1- or 2-dimensional codes), the pattern of elevated dots may also be used for the formation of processing marks (i.e. marks used for alignment, registration, or some other process-workflow-related purposes), such as alignment marks of the type discussed herein above.

## Code readers

In one embodiment, a CCD camera of a mobile phone is used for reading the dotted code information. An app on the phone converts the coded information of the dot-shaped structure back into alphanumeric signs and displays the information to the user. This allows easy identification of the correct plate in a plate storage, e.g. for a redo job by the user.

In another embodiment a camera mounted on a XY-cutting table may be moved over the portions of the plate where the non-printing code is located to read cutting information implemented in the code.

In applications in which the size of the code patch is not sufficiently large to contain all of the information desired to place within the code, the code patch may contain information that points towards a server address. Thus, instead of putting the full information into the code, further details are stored in a computer file at a server accessible to the mobile phone or another reading device over a network, such as over a global computer network, or via WLAN, LAN, or other network technologies.

This foregoing systems and methods may also be used to store information about the printing plates usage such as:

a) Date of manufacturing
b) Date of Print runs
c) Approximate total Number of imprints

Such information improves knowledge about printing plate wear before mounting the plate on a press and may facilitate decision making as to when to order a new plate.

Additional and more detailed information about readers and information storage may be found in any of Applicant's prior filings mentioned in the background section hereof, as well as in one or both of Application Ser. Nos. PCT/EP21/082848, titled SYSTEM AND METHOD FOR TRACKING PRINTING SYSTEM METRICS AND PERFORMING PREDICTIVE MONITORING OF A PRINTING TOOL and PCT/EP21/082790, titled PRINTING PLATES WITH PRINTING STRUCTURES HAVING MULTIPLE ELEVATIONS, SYSTEMS AND PROCESSES FOR THEIR MANUFACTURE, AND METHODS FOR USE THEREOF, both filed 24 November 2021 by the Applicant of this invention, incorporated herein by reference for all purposes.

Material elevations on a substrate acting as reflecting points for incoming light may also be applicable to applications other than as embodied in photopolymer printing plates. Another use case includes providing printing elevations with clear paint on transparent foils. Such printed elevations are essentially invisible under daylight conditions, but become visible when the foil is illuminated by a point light source, such as an LED. An additional foil may be laminated onto the foil printed with the dots as a protective layer to make the printed dots more rugged.

While most photopolymer printing plates are completely or semitransparent to light in the visible range, the application of dot structures may also be implemented on opaque materials and detected by changes in light reflectivity.

Optical-property-altering dots may also be applied by removing material from a surface, such as, for example, by etching, grinding, drilling, embossing, thermoforming and any other method of material processing known in the art. The use of such process may enable use in connection with a wide variety of materials other than photopolymer, such as glass or metal. Aspects of the invention are therefore not limited to any particular materials of construction or any particular method or system for forming the dot-based indicia.

As distinguished from the use of information in the form of braille, such dot-based indicia may be read based on the differences in optical properties (i.e. boundary properties) of the isolated dots relative to non-dot areas of the surface in the presence of applied light. The differences in optical properties may be detectable and readable by the human eye, or in preferred implementations, machine-readable. Preferred implementations include the use of a camera (such as in a mobile device) to, for example, read a machine-readable 1- or 2-dimensional code (e.g. QR code or barcode) formed by dots that may be relatively less perceptible to the naked human eye than, for example, printed content, but that are clearly distinguishable when captured an in image taken by a camera that may be more sensitive to differences in optical properties or that may capture the image in conjunction with the use of applied light (i.e. incident light from a flash, or light from one or more other light sources reflecting, refracting, and/or transmitting light from or through the isolated dots and the surrounding surface).

In applications in which any of the one or more patterns discussed herein correspond to a digital 1- or 2-dimensional codes, the step of reading the code may be performed by a camera connected to one or more processors (e.g. a mobile phone, in which the one or more processors may include an internal processor and/or one or more processors accessible to the mobile device over a public or private network, such as software as a service (SAAS) hosted "in the cloud" and accessible over a global computer network). The process of communicating information using the isolated dots may further comprise the one or more processors translating the information embodied by the pattern of isolated dots and read by the reader into one or more instructions readable by a machine or into alphanumeric information readable by a human, which information may be usable for any of the purposes as described herein, generally. Implementations are not limited to those associated with a printing workflow, and the machine readable instructions may include any instruction readable by any machine or processor to cause the machine or the processor to instruct another machine connected to the processor to perform any act related to the article marked with the dot pattern. Translation of the information may include direct translation of the code to the machine or human readable information, or may include transition of the code to an address in computer memory assessable via a network, wherein the address contains the corresponding human or machine readable information. Translation may include more than one translation step from the initial information as embodied by the code to the end information readable by the machine or human. Translation may include using a lookup table or an algorithm or any means known in the art for translating one type of information to another.

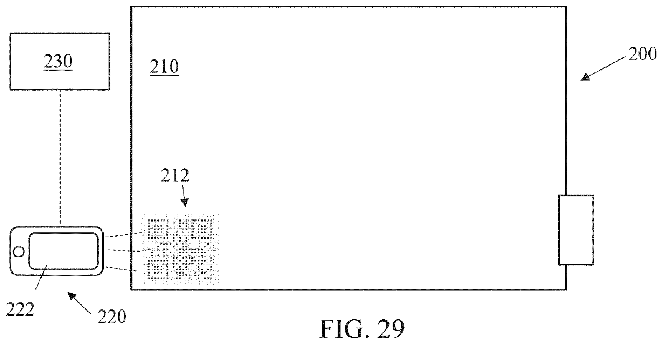

In preferred embodiments, processing equipment in a workflow are provided with or connected to a scanner or other information capture device, herein referred to as a "reader," which allows reading the indicia to obtain the associated process parameters. Thus, in preferred embodiments, process information is scanned from the plate (or other article) and the relevant process parameters are set accordingly. For example, in system 200 as depicted in FIG. 29, where the indicia 212 on plate 210 comprises a visible code, such as a QR code or a barcode, the reader 220 may comprise a mobile device, such as a mobile phone, a handheld computer, a tablet, or the like. Although reader 220 is depicted as a "phone," it should be understood that the figure is intended to be a schematic representation of any applicable reader, and may comprise any type of reader known in the art suitable for reading the indicia provided. The technologies and apparatus associated with reading 1- and 2-dimensional codes are well understood in the art. Reader 220 is connected to controller 230 of the apparatus for performing the identified process step. The connection between the reader and the controller may be a wired or wireless connection. An exemplary wireless connection may comprise a local wireless network running on computers local to a facility in which the processing step is located, or may be a network connected to a global information network or wireless communication network. Controller 230 may be programmed with instructions for translating the information derived from the indicia into the information required to set the corresponding parameters of the processing equipment, or the translation instructions may be contained in the reader. The information derived from the reader may be embedded directly in the indicia, or the indicia may comprise information corresponding to an address in computer storage on a network where the information resides in communication with the reader and the controller. The information corresponding to the address may be a URL, a process identifier, or a unique plate identifier. In an embodiment in which the information is a unique plate identifier, the system may be configured to use the unique plate identifier to find the corresponding instructions, such as using by using the plate identifier to query a lookup table that resides at a known address. In embodiments where tracking specific plates is not of interest, and where the processing instructions corresponding to the universe of plates to be processed have only a limited number of permutations, the information corresponding to the address may be a process identifier rather than a unique plate identifier. In such embodiments, the process identifier may be used for querying a corresponding lookup table of process instructions corresponding to each process identifier. In embodiments in which the instructions are embedded in the identifier, the indicia may also further embody a unique plate identifier, wherein the plate identifier may be used for tracking the plate or identifying the plate, such as with a mobile device, as described herein later.

Process information may include, for example and without limitation in a plate manufacturing process workflow: the job name, customer name, printer's name, plate type, plate thickness, back exposure energy, preferred back exposure time, main exposure energy, preferred main exposure time, number of main exposure cycles, plate processing speed, plate processing temperature, plate cutting path, plate cutting speed, and the like.

In one embodiment of the invention, process information is stored in the indicia 212, such as a QR code. Reading a QR code from a plate can be performed with an existing QR-code reader (i.e. a code scanner) known in the art. For example, a model C5PC003 code scanner from Wenglor is suitable for omnidirectional scanning of 1D and 2D codes, including but not limited to 1D codes (commonly referred to as "barcodes"), such as Code39, Code93, Code128, UPC/EAN, BC412, Interleaved 2 of 5, Codabar, Postal Codes, Pharmacode, and 2D codes, such as DataMatrix ECC 0...200, PDF417, Micro PDF417, QR-Code, Micro QR-Code, Aztec Code, GS1 Databar, and Dot code. The indicia used for providing the information is not limited to any particular type of code. In order to increase contrast and readability of the code on the plate, light from a light source (not shown), such as a light typically associated with a camera flash for a mobile device, may be applied from the bottom or the top of the plate. In preferred embodiments, process parameters for different stages are embodied directly in the code such that each individual processing unit can derive instructions directly from the code on the plate without having to connect to a network. In other embodiments, the code may comprise a computer storage address where the process information is stored, and the reading step comprises reading the information, connecting to the storage address embedded in the information such as via a hyperlink, reading the information from the storage address, and communicating relevant stored information to the processing machine.

The processes, systems, and photopolymer printing plates as described herein may include flexographic photopolymer plates, digital photopolymer printing plates, analog photopolymer printing plates, cylindrical printing sleeves, letterpress plates, or plates made using liquid photopolymer. As used herein, the term "printing plate precursor" refers to the precursor to a finished printing plate at any step in the process of its manufacture, including imagine, exposure, development, and post-development processing (e.g. finishing, detacking) prior to the finished printing plate being ready to receive ink. It should be understood that reference to a "printing plate" or "plate" may be used in shorthand to refer the precursor or to a finished printing plate, without limitation, which will be clear to those of skill in the art based upon the context of such use.

Various aspects of the invention are enumerated below:

1. A process for creating a printing plate from a photopolymer printing plate precursor, the printing plate having a front side for receiving ink for printing on a substrate, a back side opposite the front side, the process comprising the steps of:

   a. providing a printing plate precursor comprising uncured photopolymer disposed between the front side and the back side, with a mask disposed on the front side, the mask having openings therein;

   b. exposing the photopolymer of the printing plate precursor to actinic radiation from the front side through the mask openings, thereby curing portions of the photopolymer sufficient to form at least a part of a floor of the printing plate;

   c. optionally, exposing the photopolymer to actinic radiation from the back side of the printing plate precursor;

   d. processing the printing plate precursor to remove non cured polymer.

2. The process of aspect 1, comprising creating at least one non-printing structure having an elevation lower than an elevation of the floor.

3. The process of aspect 1, comprising creating at least one non-printing structure having an elevation higher than an elevation of the floor.

4. The process of any one of aspects 1-3, wherein the non-printing structure is an alignment mark for aligning the plate on a printing cylinder or for aligning the printing plate in a printing press.

5. The process of any one of aspects 1-4, comprising creating a non-printing edge around the at least one non-printing structure, the edge having an elevation different from the elevation of the floor and different from the elevation of the at least one non-printing structure.

6. The process of any of the forgoing aspects, wherein the photopolymer printing plate is a flexographic printing plate, a digital printing plate, an analog printing plate, a printing sleeve, a letterpress plate, or a plate made from liquid polymer.

7. The process of any one of the forgoing aspects, wherein the mask openings comprise a plurality of lines.

8. The process of aspect 7, wherein the lines comprise straight lines oriented parallel to an imaging direction of the imager

9. A process for creating a photopolymer printing plate for use in a printing step, the photopolymer printing plate having a front side for receiving ink for printing on a substrate, a back side opposite the front side, the process comprising:

providing printing indicia on the plate, the printing indicia configured to receive and transfer ink to create a printed image in a printing step;

providing visible non-printing indicia on the printing plate, wherein the visible non-printing indicia is configured not to receive and transfer ink in the printing step, the non-printing indicia disposed on a floor of the printing plate using areas of presence and absence of polymer in the plate floor, the non-printing indicia disposed on a floor of the printing plate using at least two different types of microstructures, the step of providing the visible non-printing indicia including imaging a masking layer of a printing plate precursor and processing the printing plate precursor to produce the printing plate.

10. The process of aspect 9, wherein the at least two types of microstructures include a plurality of relatively smaller microstructures sized for curing polymer to a first elevation and a plurality of relatively larger microstructures sized for curing polymer to a second elevation.

11. The process of aspect 10, wherein the first elevation defines the plate floor and the second elevation is defined above the plate floor.

12. The process of aspect 10 wherein the second elevation defines the plate floor, and the first elevation is defined below the plate floor.

13. The process of any one of aspects 10-12, wherein at least one of the types of microstructures comprise microdots.

14. The process of any one of aspects 10-13, wherein at least one of the two types of microstructures comprises microlines.

15. The process of any one of aspects 10-14, comprising forming a non-printing edge around the non-printing indicia, the edge having an elevation different from an elevation of the floor and different from an elevation of the at least one non-printing indicia.

16. The process of any one of aspects 10-15, wherein the non-printing indicia comprises an alignment mark for aligning the printing plate on a printing cylinder or for aligning the printing cylinder in a printing press.

17. The process of any one of aspects 10-16, comprising creating the floor of the plate without exposing the printing plate to actinic radiation from the back side of the plate.

18. The process of aspect 4, wherein the alignment mark comprises an isolated micro alignment mark.

19. The process of aspect 18, wherein the isolated micro alignment mark is formed by superimposing a repeating pattern of microstructures over a solid dot shape.

20. A printing plate that is a product of the process of any one of aspects 1-17.

21. A printing plate that is a product of the process of any one of aspects 18-19.

22. A system for orienting a printing plate on a substrate, the system comprising ring of LEDs visible from a front, printing surface of the printing plate disposed on the substrate, the system configured to receive a printing plate of aspect 21 in an orientation in which the isolated micro alignment mark is characteristically illuminated by the ring of LEDs when the printing plate is aligned on the substrate with the isolated micro alignment mark in a desired location centered relative to the LED ring.

23. The system of aspect 22, further comprising a camera oriented to capture an image of the isolated micro alignment mark in the desired location and a display for displaying the captured image.

24. A method for orienting a printing plate, the method comprising the steps of:

providing a ring of LEDs disposed to illuminate a surface of the printing plate;

illuminating the ring of LEDs;

providing the printing plate of claim 21 in an illumination field of the ring of LEDs while observing light reflected by the printing plate;

adjusting a location of the plate until a characteristic illumination pattern of the isolated micro alignment mark by the ring of illuminated LEDs is observed, signifying that the isolated micro alignment mark is centered relative to the LED ring.

25. A system for making a photopolymer printing plate, the system comprising:
means for providing non-printing indicia on the photopolymer printing plate, the non-printing indicia disposed on a floor of the photopolymer printing plate using at least two types of microstructures, including a first plurality of microstructures sized configured for curing photopolymer to a first elevation and a second plurality of microstructures configured for curing photopolymer to a second elevation.

26. A non-transitory computer readable storage medium having data stored therein representing instructions for imaging a first plurality of printing mask openings defining a screened image for resolving to printing structures on a printing plate and a second plurality of non-printing mask openings defining non-printing indicia comprising at least two different types of microstructures.

27. The non-transitory computer readable storage medium of aspect 26, further comprising instructions for imaging mask openings that resolve to at least a portion of a floor of the printing plate, wherein one of the at least two different types of microstructures is configured to resolve to the floor of the printing plate and another of the at least two different types of microstructures is configured to resolve to an elevation above or below the floor of the printing plate.

28. The non-transitory computer readable storage medium of aspect 27, further comprising instructions for imaging mask openings that resolve to a non-printing edge of the at least one non-printing indicia, the edge having an elevation different from the elevation of the floor and the elevation of the at least one non-printing indicia.

29. The non-transitory computer readable storage medium of any one of aspects 26-28, wherein at least one of the at least two different types of microstructures comprises a linear microstructure.

30. A process for making a flexo plate, the process comprising providing non-printing indicia disposed on a floor of the printing plate using areas of presence and absence of polymer in the plate floor, wherein the non-printing indicia is disposed on a floor of the printing plate in form of structures derived from imaging microdots, wherein the non-printing indicia comprises human-readable text oriented for reading from a back side of the printing plate.

31. The process of aspect 30, further comprising viewing the indicia directly from the back side of the plate while illuminating the back side of the printing plate.

32. The process of aspect 30, further comprising viewing a projection of an image of the indicia on a surface disposed a distance from a back of the printing plate formed by directing illumination from the front side of the plate through the printing plate and onto the surface.

33. A system for orienting a printing plate relative to a workstation, the system comprising:

a ring of LEDs disposed to illuminate a surface of the printing plate;

a positioner for positioning the ring of LEDs in a predetermined alignment position;

means for adjusting a location of the plate relative to an illumination field of the ring of LEDs;

means for detecting a characteristic illumination pattern of an isolated micro alignment mark disposed on a surface of the printing plate, signifying that the isolated micro alignment mark is centered relative to the LED ring.

34. The system of aspect 33, further comprising an image capture device disposed to capture light from the ring of LEDs as reflected by the printing plate.

35. The system of aspect 32, wherein the means for detecting the characteristic illumination pattern comprises a machine vision system.

36. A process for making a printing plate, the process comprising providing non-printing indicia disposed on a floor of the printing plate using areas of presence and absence of polymer in the printing plate floor, wherein the non-printing indicia is disposed on a floor of the printing plate in form of structures derived from imaging a plurality of supercells defined by a plurality of exposed pixels and unexposed pixels disposed within a supercell boundary, each supercell comprising a first number of exposed pixel clusters, each exposed pixel cluster comprising a second number of exposed pixels, the exposed pixel clusters spaced apart from one another by a third number of unexposed pixels, and a padding between the supercell boundary and a closest exposed pixel cluster defined by a fourth number of unexposed pixels.

37. The process of aspect 36, wherein each supercell comprising five exposed pixel clusters including a central pixel cluster, and four outer pixel clusters, each outer pixel cluster having an innermost corner spaced diagonally from a corner of the central pixel cluster by the third number of unexposed pixels, and the fourth number of pixels comprising a diagonal arrangement of pixels from an outermost corner of each outer pixel cluster to a corner of the supercell boundary.

38. The process of aspect 36 or aspect 37, wherein the non-printing indicia comprises one or more crossing regions where a first character portion crosses a second character portion, wherein an elevation of the crossing region of the non-printing indicia is the same as an elevation of a non-crossing region of the non-printing indicia.

39. A non-transitory computer readable storage medium having data stored therein representing instructions for imaging a first plurality of printing mask openings defining a screened image for resolving to printing structures on a printing plate and a second plurality of non-printing mask openings defining non-printing indicia, wherein the non-printing mask openings are defined by a plurality of supercells, each supercell comprising a plurality of exposed pixels corresponding to pixels for imaging mask openings and unexposed pixels corresponding to pixels not for imaging mask openings, the exposed pixels and unexposed pixels disposed within a supercell boundary, each supercell comprising a first number of exposed pixel clusters, each exposed pixel cluster comprising a second number of exposed pixels, the exposed pixel clusters spaced apart from one another by a third number of unexposed pixels, and a padding between the supercell boundary and a closest exposed pixel cluster defined by a fourth number of unexposed pixels..

40. The non-transitory computer readable storage medium of aspect 39, wherein each supercell comprises five exposed pixel clusters including a central exposed pixel cluster, and four outer exposed pixel clusters, each outer exposed pixel cluster having an innermost corner spaced diagonally from a corner of the central exposed pixel cluster by the third number of unexposed pixels, and the fourth number of pixels comprising a diagonal arrangement of pixels from an outermost corner of each outer pixel cluster to a corner of the supercell boundary.

41. A process for placing non-printing image information on a floor of a flexographic photopolymer printing plate, the method comprising forming a series of isolated non-printing dots corresponding to the non-printing image information, each dot in the series of isolated dots having a non-printing elevation above the plate floor, the series of isolated dots forming one or more patterns that represent one or more alphanumeric signs, digital codes, or alignment marks.

42. The process of aspect 41, wherein the process comprising disposing a mask on top of the photopolymer plate in an uncured state, imaging the mask to form an imaged mask in accordance with an image file comprising machine readable instructions that are based at least in part upon the non-printing image information, curing the photopolymer with actinic radiation through the mask, and removing uncured polymer, wherein each isolated non-printing dot on the plate corresponds to a presence of a supercell comprising a pixel cluster of openings in the mask.

43. The process of aspect 41 or aspect 42, further comprising selecting characteristics for the supercell based upon plate type, plate thickness, curing parameters of the actinic radiation, and resolution of image file.

44. The process of aspect 43, storing a plurality of optimal supercell characteristics as a set of machine readable instructions in a computer memory library, wherein the selecting step comprises selecting the characteristics for the supercell from the computer memory library with a computer, and forming the machine readable instructions in the image file corresponding to the non-printing image information based upon the selected characteristics.

45. The process of any one of aspects 41-44, wherein the mask comprises a laser ablateable mask, a photosensitive film, or a thermosensitive film.

46. The process of any one aspects 42-45, wherein positioning of the isolated non-printing dots on the plate floor is calculated by segmenting a non-printing image file containing non-printing image information into individual sections that correspond to the size of the supercell and combining each section of the non-printing image file information with a supercell by conjunction.

47. The process of any one aspects 42-45, further comprising combining the supercell with the non-printing image information by conjunction and combining the resulting combined non-printing image information with printing image information by disjunction.

48. The process of aspect 47, wherein the disjunction operation is an OR operation or a NAND operation.

49. A printing plate that is a product of the process recited in any one of aspects 41-48.

50. A printing plate comprising non-printing elevations on a floor of the plate floor comprising a plurality of isolated microdots arranged in a pattern corresponding to one or more alphanumeric signs or codes.

51. The printing plate of aspect 50, wherein the alphanumeric signs or codes correspond to information about the plate, processing parameters for the plate, or use of the plate, or to a link to a data file stored in computer memory containing machine readable instructions corresponding to the information about the plate, the processing parameters for the plate, or the use of the plate.

52. A process for communicating information on an article, the process comprising:

forming on a surface of the article a series of isolated optical-property-altering dots corresponding to the information, each dot in the series of isolated dots having an elevation above or below a surrounding surface of the article, the series of isolated dots forming one or more patterns that represent one or more alphanumeric signs, digital codes, or processing marks, and

reading the one or more patterns based upon distinguishable optical properties between light applied to the series of isolated dots relative to light applied to the surrounding surface of the article.

53. The process of aspect 52, comprising forming the isolated dots with a transparent or translucent coating.

54. The process of aspect 53, further comprising laminating a protective layer over the dots formed by the coating.

55. The process of any one of aspects 52 or 53, wherein the surrounding surface of the article is opaque.

56. The process of aspect 52, wherein the article comprises a printing plate.

57. The process of aspect 56, wherein the printing plate comprises a photopolymer printing plate and each isolated dot is a non-printing dot that has an elevation above or below a floor of the plate.

58. The process of aspect 57, wherein the process of forming the isolated dots comprises disposing a mask on top of the photopolymer plate in an uncured state, imaging the mask to form an imaged mask in accordance with an image file comprising machine readable instructions that are based at least in part upon the non-printing image information, curing the photopolymer with actinic radiation through the mask, and removing uncured polymer.

59. The process of aspect 58, wherein each dot corresponds to a presence of a supercell comprising a pixel cluster of openings in the mask.

60. The process of aspect 58, comprising forming a matrix of supercells that define a raised area, wherein selected absences of supercells define sunken structures relative to the raised area that form the one or more patterns.

61. The process of any one of aspects 52-60, wherein each dot corresponds to a presence of the supercell and is elevated relative to the plate floor, the one or more patterns comprises a digital 2-dimensional code, and the reading is performed by a camera connected to one or more processors.

62. The process of aspect 61, further comprising the one or more processors translating the information embodied by the isolated dots and read by the mobile device into an instruction readable by a machine or into alphanumeric information readable by a human.

Although the invention is illustrated and described herein with reference to specific embodiments and aspects, the invention is not intended to be limited to the details shown. Rather, various modifications may be made in the details within the scope and range of equivalents of the claims and without departing from the invention.
Further features, aspects and embodiments are provided below in the following items:

1. A process for creating a printing plate from a photopolymer printing plate precursor, the printing plate having a front side for receiving ink for printing on a substrate, a back side opposite the front side, the process comprising the steps of:

a. providing a printing plate precursor comprising uncured photopolymer disposed between the front side and the back side, with a mask disposed on the front side, the mask having openings therein;

b. exposing the photopolymer of the printing plate precursor to actinic radiation from the front side through the mask openings, thereby curing portions of the photopolymer sufficiently to form at least a part of a floor of the printing plate;

c. optionally, exposing the photopolymer to actinic radiation from the back side of the printing plate precursor;

d. processing the printing plate precursor to remove non cured polymer.

2. The process of claim 1, comprising creating at least one non-printing structure having an elevation higher than an elevation of the floor, creating at least one non-printing structure having an elevation lower than an elevation of the floor, or a combination thereof,
wherein the non-printing structure preferably is an alignment mark for aligning the plate on a printing cylinder or for aligning the printing plate in a printing press.

3. The process of claims 2, comprising creating a non-printing edge around the at least one non-printing structure, the edge having an elevation different from the elevation of the floor and different from the elevation of the at least one non-printing structure.

4. The process of any one of the foregoing claims, wherein the at least one non-printing structure defines non-printing indicia formed by at least two different types of microstructures.

5. The process of claim 4, wherein the at least two types of microstructures include a plurality of first microstructures sized for curing polymer to a first elevation and a plurality of second microstructures sized for curing polymer to a second elevation, optionally wherein the first elevation defines the plate floor and the second elevation is defined above the plate floor or wherein the second elevation defines the plate floor, and the first elevation is defined below the plate floor
wherein at least one of the types of microstructures preferably comprise microdots.

6. The process of any one of the foregoing claims, comprising creating the floor of the plate without exposing the printing plate to actinic radiation from the back side of the plate.

7. The process of any one of the foregoing claims in combination with claim 2, wherein the alignment mark comprises an isolated micro alignment mark.

8. A system for orienting a printing plate on a substrate, the printing plate having at least one isolated micro alignment mark formed by the process of claim 7, the system comprising ring of LEDs visible from a front, printing surface of the printing plate disposed on the substrate, the system configured to receive a printing plate in an orientation in which the isolated micro alignment mark is characteristically illuminated by the ring of LEDs in a characteristic illumination pattern when the printing plate is aligned on the substrate with the isolated micro alignment mark in a desired location centered relative to the LED ring, the system optionally comprising a camera oriented to capture an image of the isolated micro alignment mark in the desired location and a display for displaying the captured image.

9. A method for orienting a printing plate having at least one isolated micro alignment mark formed by the process of claim 7, the method comprising the steps of:

providing a ring of LEDs disposed to illuminate a surface of the printing plate;

illuminating the ring of LEDs;

providing the printing plate in an illumination field of the ring of LEDs while observing light reflected by the printing plate;

adjusting a location of the plate until a characteristic illumination pattern of the isolated micro alignment mark by the ring of illuminated LEDs is observed, signifying that the isolated micro alignment mark is centered relative to the LED ring.

10. The system of claim 9, further comprising:

a positioner for positioning the ring of LEDs in a predetermined alignment position;

means for adjusting a location of the plate relative to an illumination field of the ring of LEDs;

means for detecting the characteristic illumination pattern of an isolated micro alignment mark disposed on a surface of the printing plate, signifying that the isolated micro alignment mark is centered relative to the LED ring, the system optionally including an image capture device disposed to capture light from the ring of LEDs as reflected by the printing plate, and optionally wherein the means for detecting the characteristic illumination pattern comprises a machine vision system.

11. A non-transitory computer readable storage medium having data stored therein representing instructions for imaging a first plurality of printing mask openings defining a screened image for resolving to printing structures on a printing plate and a second plurality of non-printing mask openings defining non-printing indicia comprising at least two different types of microstructures, optionally wherein one of the at least two different types of microstructures is configured to resolve to the floor of the printing plate and another of the at least two different types of microstructures is configured to resolve to an elevation above or below the floor of the printing plate, and further optionally comprising instructions for imaging mask openings that resolve to a non-printing edge of the at least one non-printing indicia, the edge having an elevation different from the elevation of the floor and the elevation of the at least one non-printing indicia.

12. A process for making a printing plate, the process comprising providing non-printing indicia disposed on a floor of the printing plate using areas of presence and absence of polymer in the printing plate floor, wherein the non-printing indicia is disposed on a floor of the printing plate in form of structures derived from imaging a plurality of supercells defined by a plurality of exposed pixels and unexposed pixels disposed within a supercell boundary, each supercell comprising a first number of exposed pixel clusters, each exposed pixel cluster comprising a second number of exposed pixels, the exposed pixel clusters spaced apart from one another by a third number of unexposed pixels, and a padding between the supercell boundary and a closest exposed pixel cluster defined by a fourth number of unexposed pixels.

13. The process of claim 12, wherein each supercell comprising five exposed pixel clusters including a central pixel cluster, and four outer pixel clusters, each outer pixel cluster having an innermost corner spaced diagonally from a corner of the central pixel cluster by the third number of unexposed pixels, and the fourth number of pixels comprising a diagonal arrangement of pixels from an outermost corner of each outer pixel cluster to a corner of the supercell boundary.

14. A non-transitory computer readable storage medium having data stored therein representing instructions for causing an imager to image the plurality of supercells of claims 12 or 13.

15. A process for placing non-printing image information on a floor of a flexographic photopolymer printing plate, the method comprising forming a series of isolated non-printing dots corresponding to the non-printing image information, each dot in the series of isolated dots having a non-printing elevation above the plate floor, the series of isolated dots forming one or more patterns that represent one or more alphanumeric signs, digital codes, or alignment marks.

16. The process of claim 15, wherein the process comprising disposing a mask on top of the photopolymer plate in an uncured state, imaging the mask to form an imaged mask in accordance with an image file comprising machine readable instructions that are based at least in part upon the non-printing image information, curing the photopolymer with actinic radiation through the mask, and removing uncured polymer, wherein each isolated non-printing dot on the plate corresponds to a presence of a supercell comprising a pixel cluster of openings in the mask and/or
wherein positioning of the isolated non-printing dots on the plate floor is calculated by segmenting a non-printing image file containing non-printing image information into individual sections that correspond to the size of the supercell and combining each section of the non-printing image file information with a supercell by conjunction, optionally further comprising combining the supercell with the non-printing image information by conjunction and combining the resulting combined non-printing image information with printing image information by disjunction.

## Claims

1. A system for orienting a printing plate (1510) on a substrate (1502), the system comprising a ring of LEDs (1524) visible from a front, printing surface of the printing plate (1510) disposed on the substrate (1502), wherein the system is configured to receive a printing plate (1510) having an isolated micro alignment mark (1512, 3102) in an orientation in which the isolated micro alignment mark (1512, 3102) is characteristically illuminated by the ring of LEDs (1524) when the plate (1510) is aligned on the substrate with the isolated micro alignment mark (1512, 3102) in a desired location centered relative to the LED ring (1524).

2. The system of claim 1, further including a camera (1520) oriented to capture an image of the isolated micro alignment mark (1512, 3102) in the desired location and a display (1522) for displaying the captured image.

3. The system of claim 1 or 2, wherein the isolated micro alignment mark (1512, 3102) has a diameter of about 130 $\mu$m and a height of about 50 $\mu$m.

4. The system of any one of claims 1 to 3, wherein the ring of LEDs (1524) comprises 8 LEDs (1504a-h).

5. The system of any one of claims 1 to 4, wherein the ring of LEDs (1524) is disposed on a substrate (1523).

6. The system of any one of claims 1 to 5, further comprising one or more optics (1525) configured to enhance visibility of a characteristic pattern to a viewer (1520), wherein, optionally, the one or more optics (1525) are centred relative to the substrate (1523).

7. The system of any one of claims 1 to 6, wherein the isolated micro alignment mark (1512, 3102) is centered relative to the LED ring (1524) when a center of the isolated micro alignment mark (1512, 3102) is aligned relative to a central axis perpendicular to the printing plate (1510) defined by the ring of LEDs (1524) within a desired degree of tolerance.

8. The system of any one of claims 1 to 7, wherein the substrate (1502) is a substrate for receiving the plate (1510) in a printing or pre-printing process workstation, wherein, optionally, the substrate includes a cutting table, a mounting unit for mounting a plate portion on a substrate, a drum or other surface for aligning a plate for a printing step.

9. The system of any one of claims 1 to 8, wherein the ring of LEDs (1524) is disposed on a camera system having an alignment system in which a positioner (1530) controlled by a positioning controller (1532) associated with the camera system, is configured to position the camera at a predetermined coordinate and the plate (1510) is moved into a position in which the isolated micro alignment mark (1512, 3102) is centered relative to the ring of LEDs (1524) as determined by the characteristic illumination observed on a display.

10. The system of any one of claims 1 to 9, a determination of alignment is made automatically using a machine vision system (1537).

11. The system of any one of claims 1 to 10, further comprising means (1524) for adjusting a position of the plate (1510) or plate portion bearing the isolated micro alignment mark (1512, 3102), wherein, optionally, the means (1524) comprise a machine, wherein, optionally, the machine being an arm of a robotic handling system.

12. The system of any one of claims 1 to 11, wherein the printing plate is a product of a process for creating a printing plate from a photopolymer printing plate precursor, the printing plate having a front side for receiving ink for printing on a substrate, a back side opposite the front side, the process comprising the steps of:

a. providing a printing plate precursor comprising uncured photopolymer disposed between the front side and the back side, with a mask disposed on the front side, the mask having openings therein;
b. exposing the photopolymer of the printing plate precursor to actinic radiation from the front side through the mask openings, thereby curing portions of the photopolymer sufficient to form at least a part of a floor of the printing plate;
c. optionally, exposing the photopolymer to actinic radiation from the back side of the printing plate precursor;
d. processing the printing plate precursor to remove non cured polymer;
e. creating at least one non-printing structure having an elevation lower than an elevation of the floor, the non-printing structure being an alignment mark for aligning the plate on a printing cylinder or for aligning the printing plate in a printing press, the alignment mark comprising the isolated micro alignment mark.

13. The system of claim 12, wherein the isolated micro alignment mark (1512, 3102) is formed by superimposing a repeating pattern of microstructures over a solid dot shape.

14. A method for orienting a printing plate including: providing a ring of LEDs (1524) disposed to illuminate a surface of the plate (1510), illuminating the ring of LEDs (1524), providing an isolated micro alignment mark (1512, 3102) in an illumination field of the ring of LEDs (1524) while observing light reflected by the plate (1510), and adjusting a location of the plate (1510) until a characteristic illumination pattern of the isolated micro alignment mark (1512, 3102) by the ring of illuminated LEDs (1524) is observed, signifying that the isolated micro alignment mark is centered relative to the LED ring.

15. The method of claim 14, further including capturing an image of the isolated micro alignment mark (1512, 3102) in the desired location and a displaying the captured image.

FIG. 1

FIG. 2

2100

FIG. 3

2200

FIG. 4

FIG. 5

FIG. 6A  FIG. 6B  FIG. 6C

FIG. 6D  FIG. 6E  FIG. 6F

FIG. 7A

FIG. 7B

FIG. 8A

FIG. 8B

FIG. 8C

FIG. 8D

FIG. 9A

FIG. 9B

FIG. 9C

FIG. 10A

FIG. 10B

FIG. 10C

FIG. 10D

FIG. 11A

FIG. 11B

FIG. 11C

FIG. 11D

3002

FIG. 12A

3004

FIG. 12B

3006

FIG. 12C

EP 4 589 386 A2

FIG. 13A          FIG. 13B          FIG. 13C

FIG. 14

FIG. 15A

FIG. 15B

FIG. 16

FIG. 18A          FIG. 18B          FIG. 18C

FIG. 17

FIG. 19

FIG. 20

FIG. 21

FIG. 22A

FIG. 22B

FIG 22C

FIG. 22D

FIG. 23

FIG. 24

FIG. 25

FIG. 26

FIG. 27

SELECT TYPE 1 SUPERCELL SUITABLE FOR GROWING NON-PRINTING STRUCTURES

281

CALCULATE SIZE OF TYPE 2 SUPERCELL FROM SELECTED TYPE 1 SUPERCELL

282

ALLOCATE DIGITAL CODE PATTERN TO TYPE 2 SUPERCELL

283

CREATE NON-PRINTING IMAGE FILE

284

COMBINE NON-PRINTING IMAGE FILE WITH PRINTING IMAGE FILE

285

SEND COMBINED IMAGE FILE TO AN IMAGER AND IMAGE THE PLATE

286

280

FIG. 28

FIG. 29

FIG. 30A

FIG. 30B

FIG. 30C

FIG. 30D

FIG. 31A

FIG. 31B

FIG. 31C

FIG. 31D

FIG. 32A

FIG. 32B

FIG. 32C

FIG. 32D

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63274202
- EP 2020078112 W
- US 62911568
- US 55970219
- US 43387319
- EP 19052536 W
- US 62653972
- EP 2397327 A2

- EP 1557279 B1
- US 20180210345 A1
- US 62839171
- US 9375916 B2
- US 20190315141 A1
- EP 21082848 W
- EP 21082790 W